(19) **Europäisches Patentamt**
**European Patent Office**
**Office européen des brevets**

(11) **EP 1 855 160 B1**

(12) **EUROPÄISCHE PATENTSCHRIFT**

(45) Veröffentlichungstag und Bekanntmachung des Hinweises auf die Patenterteilung:
**27.06.2012 Patentblatt 2012/26**

(51) Int Cl.:
*G03F 7/20* (2006.01)      *G02B 17/08* (2006.01)

(21) Anmeldenummer: **07008471.0**

(22) Anmeldetag: **26.04.2007**

(54) **Projektionsbelichtungsanlage, Projektionsbelichtungsverfahren und Verwendung eines Projektionsobjektivs**

Projection exposure device, projection exposure method and use of a projection lens

Dispositif d'éclairage de projection, procédé d'éclairage de projection et utilisation d'un objectif de projection

(84) Benannte Vertragsstaaten:
**DE FR NL**

(30) Priorität: **11.05.2006 DE 102006022958**

(43) Veröffentlichungstag der Anmeldung:
**14.11.2007 Patentblatt 2007/46**

(73) Patentinhaber: **Carl Zeiss SMT GmbH**
**73447 Oberkochen (DE)**

(72) Erfinder:
• **Rostalski, Hans-Jürgen**
**73447 Oberkochen (DE)**
• **Feldmann, Heiko**
**73432 Aalen (DE)**
• **Ulrich, Wilhelm**
**73434 Aalen (DE)**

(74) Vertreter: **Muschik, Thomas**
**Patentanwälte Ruff, Wilhelm,**
**Beier, Dauster & Partner,**
**Kronenstrasse 30**
**70174 Stuttgart (DE)**

(56) Entgegenhaltungen:
EP-A- 1 102 100      WO-A-2006/125790
DE-A1- 10 316 428    US-A- 5 212 593
US-A- 5 402 267      US-A1- 2006 082 904

**Beschreibung**

HINTERGRUND DER ERFINDUNG

Gebiet der Erfindung

Die Erfindung bezieht sich auf eine Projektionsbelichtungsanlage zur Belichtung eines im Bereich einer Bildfläche eines Projektionsobjektivs angeordneten, strahlungsempfindlichen Substrats mit mindestens einem Bild eines im Bereich einer Objektfläche des Projektionsobjektivs angeordneten Musters einer Maske sowie auf ein mit Hilfe der Projektionsbelichtungsanlage durchführbares Projektionsbelichtungsverfahren und auf die Verwendung eines Projektionsobjektivs.

Beschreibung des verwandten Standes der Technik

Zur Herstellung von Halbleiterbauelementen und anderen feinstrukturierten Bauteilen werden heutzutage überwiegend mikrolithographische Projektionsbelichtungsverfahren eingesetzt. Dabei werden Masken (Retikel) verwendet, die das Muster einer abzubildenden Struktur tragen oder bilden, beispielsweise ein Linienmuster einer Schicht (layer) eines Halbleiterbauelementes. Eine Maske wird in eine Projektionsbelichtungsanlage zwischen Beleuchtungssystem und Projektionsobjektiv im Bereich der Objektfläche des Projektionsobjektivs positioniert und mit einem vom Beleuchtungssystem bereitgestellten Beleuchtungslicht beleuchtet. Das durch die Maske und das Muster veränderte Licht verläuft als Projektionslicht durch das Projektionsobjektiv, welches als Reduktionsobjektiv ausgelegt ist und das Muster der Maske in verkleinerndem Maßstab auf das zu belichtende Substrat abbildet, das normalerweise eine strahlungsempfindliche Schicht (Fotoresist, Fotolack) trägt.

Bei der Auswahl geeigneter Projektionsbelichtungsanlagen und Verfahren für einen Lithographie-Prozess sind unterschiedliche technische und wirtschaftliche Kriterien zu berücksichtigen, die sich unter anderem an der typischen Strukturgröße der innerhalb des belichteten Substrates zu erzeugenden Strukturen orientieren. Die zu erzeugenden Strukturen der Halbleiterbauelemente können winzige metallische Bahnen und/oder Siliziumbahnen sowie andere Strukturelemente enthalten, deren kritische Dimensionen (critical dimensions, CD) deutlich kleiner sein können als die Arbeitswellenlänge des zur Abbildung verwendeten ultravioletten Lichts.

Bei der Herstellung von hochintegrierten Halbleiterbauelementen ist es häufig erforderlich, dass zumindest einige Schichten eines dreidimensionalen strukturierten Bauteiles unter Bedingungen erzeugt werden, bei denen die bildseitige numerische Apertur NA des Projektionsobjektivs und die verwendete Arbeitswellenlänge $\lambda$ des Ultraviolettlichts ausreichen, um gemäß der Gleichung $R=k_1(\lambda/NA)$ mit der prozessabhängigen Konstante $k_1<1$ eine Auflösung R zu erzielen, die für kritische Schichten z.B. unterhalb von 100 nm liegen kann. Die für solch hohe Auflösungen optimierten Projektionsbelichtungsanlagen verwenden typischerweise Arbeitswellenlängen $\lambda < 200$ nm, insbesondere $\lambda = 193$ nm oder $\lambda = 157$ nm.

Bei Wellenlängen $\lambda \leq 200$ nm stehen jedoch nur noch wenige ausreichend transparente Materialien zur Herstellung der transparenten optischen Elemente zur Verfügung. Hierzu gehören vor allem synthetisches Quarzglas (fused silica), das bis hinunter zu 193 nm ausreichend transparent ist, sowie einige Fluoridkristallmaterialien, die auch bei Wellenlängen von 157 nm und darunter noch ausreichend absorptionsarm sind. Von praktischer Bedeutung für die Herstellung von Linsen und anderen optischen Elementen sind hier vor allem Kalziumfluorid und Bariumfluorid. Da die Abbezahlen dieser Materialien jedoch relativ nah beieinander liegen, ist eine Korrektur von Farbfehlern (chromatischen Aberrationen) mit rein refraktiven Mitteln in diesem Wellenlängenbereich schwierig. Daher werden für $\lambda = 193$ nm und insbesondere für $\lambda = 157$ nm katadioptrische Projektionsobjektive verwendet, die zusätzlich zu einer Vielzahl von Linsen auch mindestens einen Konkavspiegel enthalten.

Viele bekannte katadioptrische Projektionsobjektive mit einem oder zwei Zwischenbildern haben mindestens einen Konkavspiegel, der im Bereich einer Pupillenfläche des optischen Systems angeordnet ist und in dessen unmittelbarer Nähe mindestens eine Negativlinse sitzt. Durch die pupillennahe Negativlinse kann eine chromatische Überkorrektion bereitgestellt werden, mit der die chromatische Unterkorrektion anderer Objektivteile mindestens teilweise kompensierbar ist. Beispiele solcher Projektionsobjektive mit einem einzigen Zwischenbild sowie geometrischer oder physikalischer Strahlteilung und mindestens einem ebenen Faltspiegel sind in der WO 2004/099600 A2 oder den Patenten US 6,424,471 B1 oder US 6,665,126 B2 der Anmelderin gezeigt.

Bekannt sind auch Projektionsobjektive, die aus drei hintereinander geschalteten abbildenden Objektivteilen bestehen, also zwei Zwischenbilder haben. Ein erstes, refraktives Teilsystem (Abkürzung "R") erzeugt ein erstes reelles Zwischenbild eines Objekts. Ein zweites, katadioptrisches Teilsystem (Abkürzung "C") mit einem Konkavspiegel erzeugt aus dem ersten Zwischenbild ein reelles zweites Zwischenbild. Ein drittes, refraktives Teilsystem bildet das zweite Zwischenbild in die Bildebene ab. Bei den in der US 2003/0011755 A1 gezeigten Beispielen für 157 nm Arbeitswellenlänge wird die Umlenkung des Strahlenganges zwischen diesen drei Objektivteilen durch zwei im rechten Winkel zueinander ausgerichtete Planspiegel erreicht, wodurch Objektebene und Bildebene des Projektionsobjektivs parallel zueinander ausgerichtet werden.

Es gibt auch ungefaltete katadioptrische Projektionsobjektive mit einer geradlinig durchgehender optischer Achse (in-line-Systeme), die einen pupillennah angeordneten Konkavspiegel mit zugeordneter Negativlinse sowie mindestens einen weiteren Konkavspiegel haben. Ausführungsformen für 193 nm Arbeitswellenlänge mit einem ersten katadioptrischen Objektivteil mit zwei Konkavspiegeln zur Erzeugung eines Zwischenbildes und einem zweiten, refraktiven Objektivteil zur Abbildung des Zwischenbildes auf die Bildfläche sind in der EP 1 069 488 A1 gezeigt. Aus der US 6,600,608 sind in-line Systeme mit Pupillenobskuration bekannt, die zwei pupillennahe, im genutzten Bereich durchbrochene Konkavspiegel haben.

Für die Erzeugung mittelkritischer oder unkritischer Schichten mit typischen Strukturgrößen von deutlich mehr als 150 nm wird dagegen herkömmlich mit Projektionsbelichtungsanlagen gearbeitet, die für Arbeitswellenlängen von mehr als 200 nm ausgelegt sind. In diesem Wellenlängenbereich werden rein refraktive (dioptische) Reduktionsobjektive verwendet, deren Herstellung aufgrund ihrer Rotationssymmetrie um die optische Achse gut beherrschbar ist. Seit langer Zeit sind hier vor allem Projektionsbelichtungsanlagen für eine Arbeitswellenlänge von 365,5 nm $\pm$ 2 nm (so genannte i-Linien-Systeme) im Einsatz. Sie nutzen die i-Linie von Quecksilberdampflampen, wobei deren natürliche Bandbreite mit Hilfe eines Filters oder auf andere Weise auf eine schmalere genutzte Bandbreite $\Delta\lambda$, z.B. von etwa 2 nm, eingeschränkt wird. Bei derartigen Lichtquellen wird bei der Projektion Ultraviolettlicht eines relativ breiten Wellenlängenbandes genutzt, so dass das Projektionsobjektiv eine relativ starke Korrektur von Farbfehlern leisten muss, um auch mit einem solch breitbandigen Projektionslicht bei der angestrebten Auflösung eine fehlerarme Abbildung zu gewährleisten.

Bei breitbandig betriebenen refraktiven Projektionsobjektiven werden zur Farbkorrektur verschiedene Linsenmaterialien mit ausreichend unterschiedlichen Abbezahlen verwendet, die innerhalb des Projektionsobjektivs in Bereichen unterschiedlicher Strahlhöhenverhältnisse geeignet verteilt werden, um die Farbkorrektur zu erzielen. Zu den in typischen i-Linien-Projektionsobjektiven verwendeten transparenten Materialien gehören insbesondere synthetisches Quarzglas (fused silica) sowie die unter den Bezeichnungen FK5, LF5 und LLF1 vertriebenen Spezialgläser der Firma SCHOTT, Mainz, Deutschland. Bei diesen optischen Gläsern sind das synthetische Quarzglas und das Glas FK5 typische Vertreter für Gläser mit relativ kleiner Dispersion (Krongläser), während die Gläser LF5 und LLF1 typische Vertreter für Gläser mit relativ großer Dispersion (Flint-Gläser) sind. Zur Anwendung kommen die bekannten Formen refraktiver Reduktionsobjektive mit mehreren Taillen und Bäuchen. Beispiele für verkleinernd wirkende Dreibauchsysteme mit NA > 0,6, die drei Bäuche insgesamt positiver Brechkraft und zwei Taillen insgesamt negativer Brechtkraft haben und bei denen zur Farbkorrektur definierte Verteilungen von Gläsern hoher Dispersion und Gläsern niedriger Dispersion genutzt werden, sind in der deutschen Patentanmeldung DE 102 21 386 A1 (entsprechend US 6,806,942 B2) gezeigt.

Die US-Patentanmeldung US 2005/0094289 A1 zeigt verschiedene katadioptrische Reduktionsobjektive, die in der Lage sind, bei einer relativ hohen bildseitigen numerischen Apertur NA > 0,6 Strukturen mit typischen Strukturgrößen < 250 nm abzubilden. Es handelt sich jeweils um katadioptrische Projektionsobjektive ohne Zwischenbild mit einem Konkavspiegel, wobei die Projektionsobjektive einen physikalischen Strahlteiler mit polarisationsselektiver Strahlteilerfläche haben, die bei der ersten Nutzung für die eintretende, linear polarisierte Strahlung reflektierend wirkt, um die Strahlung zum Konkavspiegel zu lenken, und in einem zweiten Durchtritt transmittierend wirkt, um die Strahlung vom Konkavspiegel zur Bildebene durchzulassen. Zwischen dem Strahlteiler und dem Konkavspiegel ist zur Polarisationsdrehung unmittelbar vor dem Konkavspiegel eine $\lambda$/4-Platte angebracht. Ein für die Quecksilber i-Linie und 8 nm Bandbreite ausgelegtes Ausführungsbeispiel hat Linsen aus verschiedenen Materialien unterschiedlicher Dispersion und Brechzahl (sog. i-Linie-Gläser), um die Korrektur von Farbfehlern zu unterstützen. Bei einem Ausführungsbeispiel, das für eine relativ schmalbandige Lichtquelle mit einer Arbeitswellenlänge von 248.4 nm und einer Bandbreite von 300 pm ausgelegt ist, bestehen alle transparenten optischen Komponenten aus synthetischem Quarzglas.

Es ist eine Aufgabe der Erfindung, eine Projektionsbelichtungsanlage zu schaffen, die in der Lage ist, mit relativ breitbandiger Projektionsstrahlung bei Arbeitswellenlängen von $\lambda$ > 200 nm eine von Farbfehlern weitgehend freie verkleinernde Abbildung von Maskenstrukturen zu gewährleisten und die gleichzeitig wirtschaftlich mit engen Qualitätstoleranzen herstellbar ist. Insbesondere sollen wirtschaftlich herstellbare Projektionsobjektive verwendet werden.

Zur Lösung dieser und anderer Aufgaben stellt die Erfindung eine Projektionsbelichtungsanlage mit den Merkmalen von Anspruch 1 bereit. Weiterhin wird die Verwendung eines katadioptrischen Projektionsobjektivs gemäß den Merkmalen von Anspruch 14 vorgeschlagen und es wird ein Projektionsbelichtungsverfahren mit den Merkmalen von Anspruch 16 bereitgestellt.

Ein "pupillennaher Bereich" in Sinne dieser Anmeldung zeichnet sich somit dadurch aus, dass im pupillennahen Bereich die Randstrahlhöhe (marginal ray height MRH) der Abbildung größer ist als die Hauptstrahlhöhe (chief ray height CRH). Vorzugsweise ist die Randstrahlhöhe im Bereich der Negativgruppe mindestens doppelt so groß wie die Hauptstrahlhöhe, insbesondere mindestens 5 bis 10 mal so groß. Dies gilt vorzugsweise für alle Linsen der Negativgruppe. Eine Negativgruppe im Bereich großer Randstrahlhöhen kann besonders wirksam zur Farbkorrektur, insbesondere zur Korrektur des Farblängsfehlers CHL, beitragen, da der Farblängsfehler CHL einer dünnen Linse proportional zum Quadrat der Randstrahlhöhe am Ort der Linse (sowie proportional zur Brechkraft und umgekehrt proportional zur Dispersion der Linse) ist.

Hinzu kommt, dass eine in unmittelbarer Nähe eines Konkavspiegels angeordnete Negativgruppe von der Projektionsstrahlung zweifach in entgegengesetzten Durchstrahlungsrichtungen durchlaufen werden kann, so dass die chromatisch überkorrigierende Wirkung der Negativgruppe doppelt genutzt wird. Der Begriff "unmittelbar" kann insbesondere bedeuten, dass zwischen der mindestens einen Negativlinse der Negativgruppe und dem Konkavspiegel kein weiteres optisches Element angeordnet ist. Die mindestens eine Negativlinse der Negativgruppe ist vorzugsweise koaxial mit dem Konkavspiegel angeordnet. Die Negativgruppe kann z.B. aus einer einzigen Negativlinse bestehen oder mindestens zwei Negativlinsen enthalten. Es ist auch möglich, dass die Negativgruppe mindestens ein diffraktives optisches Element (DOE) enthält (siehe z.B. GB 2428491 basierend auf US-Provisional-Anmeldung No. 60/699483.)

Bisher ist die Fachwelt meist davon ausgegangen, dass in Projektionsbelichtungsanlagen mit relativ breitbandig abstrahlenden Lichtquellen aus dem Wellenlängenbereich $\lambda > 200$ nm, insbesondere aus dem Bereich $\lambda > 320$ nm, refraktive Projektionsobjektive zu bevorzugen sind, da zahlreiche hinsichtlich Dispersion und Brechungsindex hinreichend unterschiedliche Linsenmaterialien für die Farbkorrektur zur Verfügung stehen und deshalb mit fertigungstechnisch gut beherrschbaren, rein refraktiven Projektionsobjektiven gearbeitet werden kann, um beispielsweise ein chromatisch korrigiertes i-Linien-Objektiv (d.h. ein Objektiv für eine Arbeitswellenlänge von ca. 365 nm) zu bauen. Diese Annahme ist jedoch heutzutage nicht mehr oder nur noch bedingt richtig. Da bereits seit mehreren Jahren in größerem Umfang Projektionsobjektive für Wellenlängen aus dem tiefen Ultraviolettbereich (DUV) gebaut werden, beispielsweise für 193 nm oder 157 nm, ist der Markt für die bei höheren Wellenlängen zur Achromatisierung (Farbkorrektur) geeigneten Gläser nicht mehr in dem Umfang gegeben, dass diese Glassorten in ausreichender Menge und Qualität zur Verfügung stehen. Die Erfinder haben erkannt, dass hieraus resultierende Probleme vermieden werden können, wenn anstelle eines chromatisch korrigierten refraktiven Projektionsobjektivs ein chromatisch korrigiertes katadioptrisches Projektionsobjektiv mit mindestens einem Konkavspiegel verwendet wird.

Dieser katadioptrische Designansatz ermöglicht es unter anderem, Projektionsobjektive mit ausreichend starker Korrektur von Farbfehlern bereitzustellen, die für die Farbkorrektur keine unterschiedlichen Linsenmaterialien benötigen. Bekanntlich kann eine Achromatisierung durch die Kombination einer Sammellinse aus einem Material mit relativ kleiner Dispersion und einer zugeordneten Zerstreuungslinse aus einem zweiten Material mit relativ großer Dispersion erreicht werden. Dabei wird die Achromatisierung einfacher, je größer der Dispersionsunterschied ist. Die hieraus resultierenden Beschränkungen bei der Materialwahl können durch die Erfindung vermieden werden. Beispielsweise ist es möglich, dass mindesten 90% aller Linsen oder auch alle Linse des Projektionsobjektivs aus einem oder mehreren Materialien gefertigt sind, die im Wesentlichen die gleiche Dispersion haben. Ein evtl. existierender Dispersionsunterschied kann kleiner sein als 10%, insbesondere kleiner als 5%. Beispielsweise kann in einem Quarzglassystem an Stelle einer Linse aus synthetischem Quarzglas auch eine Linse aus FK5 vorgesehen sein, das bei 193 nm nur eine um ca. 3% größere Dispersion hat.

Bei manchen Ausführungsformen ist vorgesehen, dass mindestens 90% aller Linsen des Projektionsobjektivs aus dem gleichen Material gefertigt sind. Vorzugsweise bestehen alle transparenten optischen Komponenten aus dem gleichen Material. Besonders die Verwendung von synthetischen Quarzglas für die überwiegende Anzahl oder alle transparenten optischen Komponenten wird als vorteilhaft angesehen, da dieses Material bis hinunter zu 193 nm ausreichend transparente Material inzwischen im großen Umfang mit hoher Qualität verfügbar ist.

Dieser vereinfachte Materialeinsatz ermöglicht eine besonders witschaftliche Fertigung. Gleichzeitig können ggf. bewährte, relativ breitbandige Lichtquellen eingesetzt werden, z.B. mit $\lambda > 320$ nm und $\Delta\lambda > 100$ pm oder $\Delta\lambda > 500$ pm oder $\Delta\lambda > 1$ nm oder mehr.

Sofern synthetisches Quarzglas als Linsenmaterial verwendet wird, kann es nützlich sein, die besonders hohen Strahlungsbelastungen ausgesetzten Linsen mit kleinen Durchmessern, z.B. in der Nähe der Bildfläche, nicht aus synthetischem Quarzglas, sondern aus einem anderen Linsenmaterial, wie Kalziumfluorid, zu fertigen, um beispielsweise Probleme durch strahlungsindizierte Brechungsindexänderung (z.B. Compaction) zu vermeiden. In diesem Fall wird das zweite Material nicht zur Farbkorrektur verwendet, sondern um die Langzeitstabilität des gesamten Projektionsobjektivs zu verbessern.

Es hat sich herausgestellt, dass es günstig ist, wenn die Durchmesser und Brechkräfte des mindestens einen optischen Elementes der Negativgruppe so ausgelegt sind, dass eine Summe von überkorrigierenden Beiträgen der Negativgruppe zur Farbkorrektur mindestens 60% der Summe der unterkorrigierenden Beiträge der übrigen optischen Elemente des Projektionsobjektivs beträgt, vorzugsweise mindestens 65% oder mindestens 70%.

Eine nach Art eines "Schupmann-Achromaten" (vgl. US 620,978) wirkende Kombination eines pupillennah angeordneten Konkavspiegels mit einer unmittelbar vor der Spiegelfläche angeordneten Negativgruppe kann in katadioptrischen Systemen mit unterschiedlichem Aufbau genutzt werden. Repräsentative Beispiele für gefaltete katadioptrische Projektionsobjektive mit mindestens einem Zwischenbild, die einen oder mehrere ebene Faltspiegel in Kombination mit einer einzigen zur Achromatisierung nutzbaren katadioptrischen Gruppe haben, sind beispielsweise in US 6,909,492 B2 oder US 2004/0160677 A1 oder US 2003/0011755 A1 gezeigt. Ungefaltete Projektionsobjektive (in-line-Systeme) mit einem pupillennah angeordneten Konkavspiegel und einem weiteren Konkavspiegel sind z.B. in der EP 1 069 448 A1 gezeigt. Andere in-line Systeme, zum Teil mit vier oder sechs Konkavspiegeln, sind in den Patenten US 6,636,350 oder US 6,995,918. Systemtypen dieser Art sind bei entsprechender Anpassung grundsätzlich im Rahmen der Erfindung nutzbar.

Die Lichtquelle umfasst bei den als "i-Linien-Systeme" bezeichneten Ausführungsformen eine Quecksilberdampflampe, bei der das abgegebene Ultraviolettlicht aus einem Wellenlängenband mit zentraler Arbeitswellen-Arbeits-wellenlänge $\lambda$ = 365,5 nm stammt. Typische Bandbreiten liegen hier im Bereich $\Delta\lambda$ = 2 nm. Alternativ kann beispielsweise ein XeF-Laser als Lichtquelle verwendet werden, der bei einer zentralen Arbeitswellenlänge aus dem Bereich um ca. 351 nm eine typische Bandbreite $\Delta\lambda$ = 0,2 nm hat. Als Lichtquelle können auch lichtemittierende Dioden (LED) genutzt werden, die bei nicht zur beanspruchten Erfindung gehörenden Systeme beispielsweise Licht um eine zentrale Arbeits-wellenlänge $\lambda$ = 248 nm bei einer Bandbreite von $\Delta\lambda$ = 10 nm aussenden. Bei herkömmlichen KrF-Excimerlasern mit einer zentralen Arbeitswellenlänge $\lambda$ = 248 nm könnte bei nicht zur beanspruchten Erfindung gehörenden Systeme die herkömmlich genutzte Bandbreiteneinengung entfallen, so dass besonders kostengünstige, breitbandige Varianten solcher Lichtquellen verwendet werden könnten.

Der Begriff "Lichtquelle" soll hier nicht nur die eine primäre Strahlung abgebende primäre Lichtquelle umfassen, sondern auch ggf. vorhandene Einrichtungen wie Filter, Blenden, Bandbreiteneinengungsmodule oder dergleichen, die dazu dienen, das Spektrum der von der primären Lichtquelle abgegebenen primären Strahlung vor Eintritt in das Beleuchtungssystem zu verändern.

Damit das Projektionsobjektiv bei einer gegebenen Wellenlänge oder einer Anzahl unterschiedlicher Wellenlänge innerhalb eines gewünschten Wellenlängenbandes für die Abbildung nutzbar ist, muss das Projektionsobjektiv so ausgelegt sein, dass eine taugliche Belichtung von Substraten unter Verwendung des Lichtes aus dem vorgegebenen Wellenlängenband möglich ist. Dieses Wellenlängenband wird häufig auch als "Design-Wellenlängenband" bezeichnet und bezeichnet einen Bereich von Wellenlängen, der diejenigen Wellenlängen enthält, für die die optische Leistungsfähigkeit des Projektionsobjektivs ausreichend gut ist, um eine beugungsbegrenzte Abbildung mit einem niedrigen Aberrationsniveau sicherzustellen. Wenn die Konfiguration des Projektionsobjektivs beispielsweise so gewählt ist, dass das Design-Wellenlängenband die Quecksilber g-, h- und i-Linie umfasst, kann das Projektionsobjektiv in Verbindung mit einer Quecksilberdampflampe hoher Leistung als Lichtquelle der Projektionsbelichtungsanlage genutzt werden. Daher ist ein Projektionsobjektiv, das für die Verwendung einer Quecksilberdampflampe ausgelegt ist, optisch derart korrigiert, dass das Wellenlängenband die Quecksilber g-, h- und i-Linien enthält. In einem solchen Fall ist die optische Leistungsfähigkeit für mindestens eine der Quecksilberlinien bei ungefähr 365 nm (i-Linie), ungefähr 405 nm (h-Linie) und 436 (g-Linie) optimiert, wogegen die optische Leistung außerhalb des Design-Wellenlängenbandes deutlich schlechter sein darf. Normalerweise ist ein Projektionsobjektiv, das ausschließlich für ein Design-Wellenlängenband mit den Quecksilber g-, h- und i-Linien ausgelegt ist, nicht geeignet, für signifikant kürzere Wellenlängen, beispielsweise aus dem tiefen Ultraviolettbereich (DUV) mit Wellenlängen kleiner als ungefähr 260 nm und/oder aus dem sichtbaren Wellenlängenbereich, beispielsweise mit Wellenlängen von mehr als ungefähr 500 nm.

Das Projektionsobjektiv kann so konfiguriert sein, dass nur ein gemeinsamer Fokus bei oder nahe bei einer Wellenlänge des Wellenlängenbandes existiert. Diese Wellenlänge kann eine der Quecksilberlinien sein, beispielsweise die i-Linie bei ungefähr 365 nm. Ein Projektionsobjektiv kann auch zwei, drei oder mehr gemeinsame Foki bei zwei oder mehr entsprechenden Wellenlängen innerhalb eines Design-Wellenlängenbandes haben. Wenn ein Projektionsobjektiv für zwei oder mehr Wellenlängen korrigiert ist, können diese Wellenlängen für die Belichtung genutzt werden, wodurch ein größerer Anteil der von der Lichtquelle abgegebenen Leistung für die Belichtung genutzt werden kann, und somit ein höherer Durchsatz von belichteten Substraten pro Zeiteinheit erzielbar ist.

Bei bevorzugten Ausführungsformen ist das Projektionsobjektiv so ausgelegt, dass mindestens ein gemeinsamer Fokus bei einer Wellenlänge $\lambda$>320 nm vorliegt. In diesem Fall kann beispielsweise ein Xenonfluoridlaser (XeF-Laser) mit einer zentralen Arbeitswellenlänge im Bereich von ungefähr 351 nm bis ungefähr 353 nm und typischer Bandbreite von 0,2 nm als primäre Lichtquelle genutzt werden. Alternativ kann die Lichtquelle eine Quecksilberdampflampe enthalten, die die Quecksilber g-, h- und i-Linie abgibt, wobei mindestens eine dieser Linien, beispielsweise die Quecksilber i-Linie bei ungefähr 365 nm, für die Belichtung genutzt werden kann. Die Erfindung betrifft auch die Verwendung eines katadioptrischen Projektionsobjektivs mit den Merkmalen von Anspruch 14.

Diese Nutzungsmöglichkeit katadioptrischer Designs verzichtet zwar bei gefalteten Varianten auf die herstellungstechnischen Vorteile rotationssymmetrischer, rein refraktiver Projektionsobjektive, jedoch erschließen sich dadurch neue Freiheitsgrade hinsichtlich der für die transparenten optischen Elemente nutzbaren Materialien. Mit einem katadioptrischen Designansatz ist es gegebenenfalls möglich, alle Linsen und anderen transparenten optischen Element aus ein und demselben Linsenmaterial, insbesondere synthetischem Quarzglas, zu fertigen. Dadurch wird die Abhängigkeit von immer schwerer in guter Qualität verfügbaren Glasmaterialien, wie FK5, LF5 oder LL1, aufgehoben.

Gemäß einem anderen Aspekt wird auch die Verwendung eines katadioptrischen Projektionsobjektivs mit mindestens einem Konkavspiegel und genau zwei Zwischenbildern zur verkleinernden Abbildung eines in einer Objektfläche des Projektionsobjektivs angeordneten Musters einer Maske in eine zur Objektfläche optisch konjugierte Bildfläche des Projektionsobjektivs mit Hilfe von Projektionslicht aus einem Wellenlängenband mit einer Bandbreite $\Delta\lambda$ >100 pm

um eine zentrale Arbeitswellenlänge λ > 320 nm bei einer bildseitigen numerischen Apertur NA > 0,6 vorgeschlagen, wobei mindestens 90% aller Linsen oder auch alle Linsen des Projektionsobjektivs aus einem oder mehreren Materialien gefertigt sind, die im Wesentlichen die gleiche Dispersion haben. Ein evtl. existierender Dispersionsunterschied kann kleiner sein als 10%, insbesondere kleiner als 5%. Die Bandbreite kann ggf. deutlich größer sein, z.B. Δλ >500 pm oder Δλ >1 nm, so dass z.B. Quecksilberdampflampen als Lichtquelle nutzbar sind.

Auch hier ist der Konkavspiegel im Bereich einer Pupillenfläche des Projektionsobjektivs angeordnet und in unmittelbarer Nähe des Konkavspiegels ist in einem pupillennahen Bereich eine Negativgruppe mit gels ist in einem pupillennahen Bereich eine Negativgruppe mit mindestens einer Negativlinse angeordnet.

Die Erfindung betrifft auch ein Projektionsbelichtungsverfahren mit den Merkmalen von Anspruch 16.

Diese und weitere Merkmale gehen außer aus den Ansprüchen auch aus der Beschreibung und den Zeichnungen hervor, wobei die einzelnen Merkmale jeweils für sich allein oder zu mehreren in Form von Unterkombinationen bei einer Ausführungsform der Erfindung und auf anderen Gebieten verwirklicht sein und vorteilhafte sowie für sich schutzfähige Ausführungen darstellen können. Ausführungsbeispiele der Erfindung sind in den Zeichnungen dargestellt und werden im Folgenden näher erläutert.

KURZBESCHREIBUNG DER ZEICHNUNGEN

Fig. 1    zeigt schematisch eine Mikrolithographie-Projektionsbelich- tungsanlage gemäß einer Ausführungsform der Erfindung;

Fig. 2    ist ein schematischer Linsenschnitt durch eine erste Ausführungs- form eines katadioptrischen Projektionsobjektivs zur Verwendung in einer Projektionsbelichtungsanlage gemäß Fig. 1;

Fig. 3    ist ein Linsenschnitt durch ein zweites katadioptrisches Projekti- onsobjektiv;

Fig. 4    ist ein Linsenschnitt durch ein drittes katadioptrisches Projektionsobjektiv;

Fig. 5    ist ein Linsenschnitt durch ein viertes katadioptrisches Projektions- objektiv;

Bei der folgenden Beschreibung bevorzugter Ausführungsformen bezeichnet der Begriff "optische Achse" eine gerade Linie oder eine Folge von geraden Linienabschnitten durch die Krümmungsmittelpunkte der optischen Komponenten. Die optische Achse wird an Faltungsspiegeln (Umlenkspiegeln) oder anderen reflektierenden Flächen gefaltet. Das Objekt ist in den Beispielen eine Maske (Retikel) mit dem Muster einer integrierten Schaltung, es kann sich auch um ein anderes Muster, beispielsweise eines Gitters, handeln. Das Bild wird in den Beispielen auf einen mit einer Photoresistschicht versehenen Wafer projiziert, der als Substrat dient. Es sind auch andere Substrate, beispielsweise Elemente für Flüssigkeitskristallanzeigen oder Substrate für optische Gitter möglich.

Die Spezifikationen der in den Zeichnungsfiguren gezeigten Ausführungsbeispiele sind in Tabellen angegeben, deren Nummerierung jeweils der Nummerierung der entsprechenden Zeichnungsfigur entspricht.

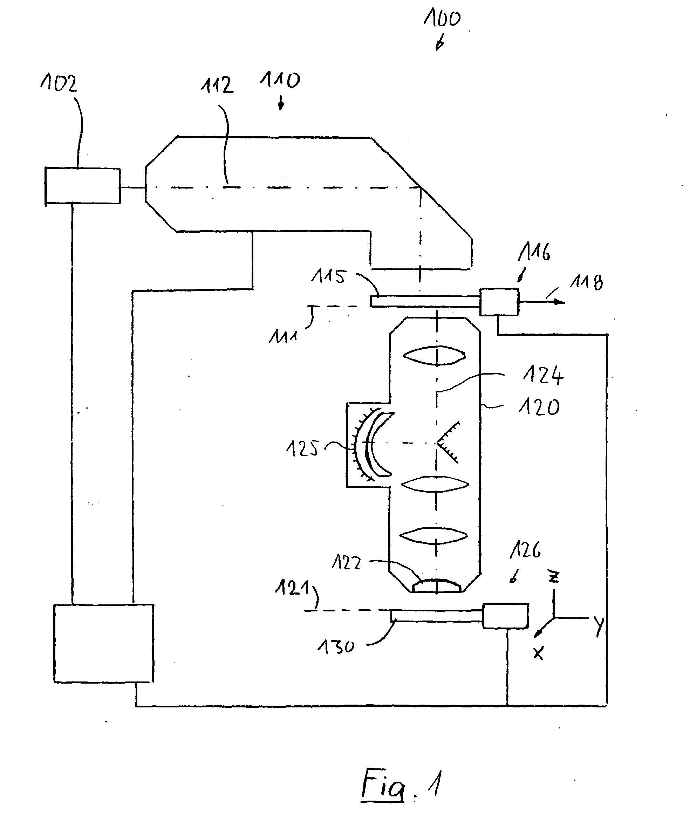

In Fig. 1 ist schematisch eine Mikrolithographie-Projektionsbelichtungsanlage 100 in Form eines Wafer-Scanners gezeigt, der zur Herstellung bestimmter Schichten (layers) von hochintegrierten Halbleiterbauelementen eingerichtet ist und je nach Einstellung Abbildungen mit einem Auflösungsvermögen bis hinunter zu R = 180 nm erlaubt. Als primäre Lichtquelle 102 wird ein Xenonfluorid-Laser (XeF-Laser) verwendet, dessen zentrale Arbeitswellenlänge bei ca. 351 nm liegt und der typische Bandbreiten von 0,2 nm hat. Ein solcher XeF-Laser hat Emissionslinien bei ca. 351 nm und ca. 353 nm. Die Emissionslinie bei 353 nm ist im Beispielsystem durch einen Filter ausgeblendet. Die verbleibenden, eng benachbarten Emissionslinien bei 351 nm haben einen Abstand von ca. 200 pm und werden bei dieser Lichtquelle gemeinsam genutzt.

Ein nachgeschaltetes Beleuchtungssystem 110 empfängt das Licht der primären Lichtquelle 102 und erzeugt in seiner Austrittsebene 111 ein großes, scharf begrenztes, sehr homogen beleuchtetes, an die Telezentriererfordernisse des nachgeschalteten Projektionsobjektivs 120 angepasstes und um die optische Achse 112 des Beleuchtungssystems zentriertes Beleuchtungsfeld. Das Beleuchtungssystem 110 hat Einrichtungen zur Auswahl des Beleuchtungsmodus und ist im Beispiel zwischen konventioneller Beleuchtung mit variablem Kohärenzgrad, Ringfeldbeleuchtung (annular illumination) und Dipol- oder Quadrupolbeleuchtung umschaltbar.

Zwischen dem austrittsseitigen letzten optischen Element des Beleuchtungssystems und dem Eintritt des Projektionsobjektivs ist eine Einrichtung 116 zum Halten und Manipulieren einer Maske 115 so angeordnet, dass ein an der Maske angeordnetes Muster einer bestimmten Schicht des zu erzeugenden Halbleiterbauelementes in der Objektebene 111 des Projektionsobjektivs liegt, die mit der Austrittsebene des Beleuchtungssystems zusammenfällt. Die optische Achse 112 des Beleuchtungssystems und die optische Achse 124 des Projektionsobjektivs sind lateral gegeneinander versetzt, um ein bezüglich der optischen Achse 124 des Projektionsobjektivs außeraxiales Feld (off-axis Feld) zu erzeugen. Die üblicherweise als "reticle-stage" bezeichnete Einrichtung 116 zum Halten und Manipulieren der Maske enthält einen Scannerantrieb, mit dem es möglich ist, die Maske parallel zur Objektfläche 111 des Projektionsobjektivs bzw. senkrecht zu den optischen Achse von Projektionsobjektiv und Beleuchtungssystem in einer Scanrichtung 118 zu verfahren.

Im Lichtweg hinter der auch als Maskenebene bezeichneten Ebene 111 folgt das Projektionsobjektiv 120, das als Reduktionsobjektiv dazu eingerichtet ist, ein verkleinertes Bild der von der Maske getragenen Struktur in reduziertem Maßstab, beispielsweise im Maßstab 4:1 oder 5:1 oder 10:1, auf einen mit einer Photoresistschicht belegten Wafer 130 abzubilden. Der als lichtempfindliches Substrat dienende Wafer 130 ist so angeordnet, dass seine ebene Substratoberfläche mit der Bildebene 121 des Projektionsobjektivs 120 zusammenfällt. Der Wafer wird durch eine Einrichtung 126 (wafer stage) gehalten, die einen Scannerantrieb umfasst, um den Wafer synchron mit der Maske 115 parallel zu dieser zu bewegen.

Das Projektionsobjektiv 120 hat als letzte, der Bildebene 121 nächste, transparente optische Komponente eine Plankonvexlinse 122, deren ebene Austrittsfläche als letzte optische Fläche des Projektionsobjektivs in einem Arbeitsabstand von einigen Millimetern oberhalb der Substratoberfläche des Wafers so angeordnet ist, dass sich zwischen der Austrittsfläche des Projektionsobjektivs und der Substratoberfläche ein gasgefüllter Spalt befindet (Trockensystem).

Das als Reduktionsobjektiv wirkende Projektionsobjektiv 120 hat zusätzlich zu einer Vielzahl von schematisch angedeuteten Linsen (typische Linsenzahlen liegen häufig bei mehr als 10 oder mehr als 15 Linsen) und gegebenenfalls anderen transparenten optischen Komponenten (mindestens) einen Konkavspiegel 125, der im Beispielsfall in der Nähe einer Pupillenfläche des Projektionsobjektivs angeordnet ist. Die bildseitige numerische Apertur des Projektionsobjektivs liegt für die im Vordergrund stehenden Anwendungen bei NA > 0,6, bei vielen Ausführungsformen zwischen ca. NA = 0.65 und NA = 0.85. Hierdurch sind bei der durch die Lichtquelle 102 vorgegebenen Arbeitswellenlänge typische Auflösungen bis hinunter zu R = 180 nm möglich.

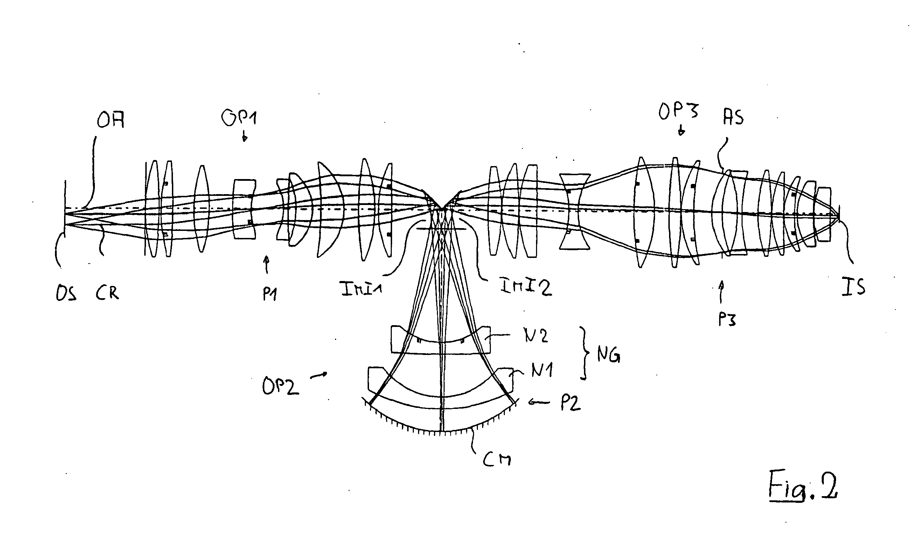

In Fig. 2 ist eine erste Ausführungsform eines katadioptrischen Projektionsobjektivs 200 gezeigt, das in der Projektionsbelichtungsanlage gemäß Fig. 1 verwendet werden kann. Es ist dafür vorgesehen, ein in seiner Objektebene OS angeordnetes Muster einer Maske in reduziertem Maßstab von 4:1 auf seine parallel zur Objektebene ausgerichtete Bildebene IS abzubilden Dabei werden zwischen Objektebene und Bildebene genau zwei reelle Zwischenbilder IMI1 und IMI2 erzeugt. Ein erster, rein refraktiver Objektivteil OP1 ist so ausgelegt, dass das in der Objektebene befindliche Muster in einem Maßstab von ca. $\beta_1$ = -0.8 in das erste Zwischenbild IMI1 abgebildet wird. Ein katadioptrischer zweiter Objektivteil OP2 bildet das erste Zwischenbild IMI1 im Wesentlichen ohne Größenänderung (Abbildungsmaßstab $|\beta_2|$ ≈ 1:1) in das zweite Zwischenbild IM12 ab. Ein dritter, rein refraktiver (dioptrischer) Objektivteil OP3 ist dafür ausgelegt, das zweite Zwischenbild IMI2 mit starker Verkleinerung ($|\beta_3 << 1$) in die Bildebene IS abzubilden. Objektfeld und Bildfeld liegen außerhalb der optischen Achse (off-axis System). Das System ist frei von Pupillenobskuration.

Das Projektionsobjektiv 200 ist ein Beispiel für ein "verkettetes" Projektionsobjektiv, das mehrere hintereinandergeschaltete, jeweils als Abbildungssysteme ausgestaltete Objektivteile hat, die über Zwischenbilder verknüpft sind, wobei das von einem im Lichtweg vorangehenden Abbildungssystem erzeugte Bild (Zwischenbild) als Objekt für das im Lichtweg nachfolgende Abbildungssystem dient, welches ein weiteres Zwischenbild erzeugen kann (wie im Fall des zweiten Objektivteils OP2) oder das letzte Abbildungssystem des Projektionsobjektivs bildet, welches das Bildfeld in der Bildebene des Projektionsobjektivs erzeugt (wie der dritte Objektivteil OP3). Systeme des in Fig. 2 gezeigten Typs werden auch als R-C-R System bezeichnet, wobei hier "R" ein refraktives Abbildungssystem und "C" ein katadioptrisches Abbildungssystem bezeichnen.

Zwischen der Objektebene und dem ersten Zwischenbild, zwischen dem ersten und dem zweiten Zwischenbild sowie zwischen dem zweiten Zwischenbild und der Bildebene liegen jeweils Pupillenflächen des Abbildungssystems dort, wo der Hauptstrahl (chief ray) CR der optischen Abbildung die optische Achse OA schneidet. Die Pupillenfläche P1 des ersten Objektivteils OP1 ist frei zugänglich. Im Bereich der zweiten Pupillenfläche P2 innerhalb des katadioptrischen Objektivteils OP2 ist ein Konkavspiegel CM angeordnet, dem eine doppelt durchtretene Negativgruppe NG mit zwei Negativlinsen N1, N2 unmittelbar vorgeschaltet ist. Die beiden Negativlinsen N1, N2 der Negativgruppe sind koaxial mit dem Konkavspiegel und ohne ein zwischengeschaltetes optisches Element direkt davor angeordnet. Im Bereich der dritten Pupillenfläche P3 innerhalb des dritten Objektivteils OP3 ist eine verstellbare Aperturblende AS angeordnet, die zwischen dem Bereich maximaler Strahldurchmesser des dritten Objektivteils und der Bildebene IS sitzt.

Soweit in dieser Anmeldung auf eine "Randstrahlhöhe" (marginal ray height, MRH) oder eine "Hauptstrahlhöhe" (chief ray height CRH) Bezug genommen wird, so sind hiermit die paraxiale Randstrahlhöhe und die paraxiale Hauptstrahlhöhe gemeint.

In Tabelle 2 ist die Spezifikation des Designs in tabellarischer Form zusammengefasst. Dabei gibt Spalte 1 die Nummer einer brechenden oder auf andere Weise ausgezeichneten Fläche, Spalte 2 den Radius r der Fläche (in mm), Spalte 4 den als Dicke bezeichneten Abstand d der Fläche zur nachfolgenden Fläche (in mm) und Spalte 5 das Material der optischen Komponenten an. Spalte 6 zeigt den Brechungsindex des Materials an und in Spalte 7 sind die nutzbaren, freien Radien bzw. der halbe freie Durchmesser oder die Linsenhöhe der Linsen (in mm) angegeben. Radius r=0 entspricht einer ebenen Fläche. In Spalte 3 sind die Asphären gekennzeichnet. Tabelle 2A gibt die entsprechenden Asphärendaten an, wobei sich die asphärischen Flächen nach folgender Vorschrift berechnen:

$$p(h)=[((1/r)h^2)/(1+SQRT(1-(1+K)(1/r)^2h^2))]+C1*h^4+C2*h^6+....$$

Dabei gibt der Kehrwert $(1/r)$ des Radius die Flächenkrümmung und $h$ den Abstand eines Flächenpunktes von der optischen Achse (d.h. die Strahlhöhe) an. Somit gibt $p(h)$ die sogenannten Pfeilhöhe, d.h. den Abstand des Flächenpunktes vom Flächenscheitel in z-Richtung (Richtung der optischen Achse). Die Konstanten K, C1, C2, ... sind in Tabelle 2A wiedergegeben.

Das objektseitig und bildseitig telezentrische Projektionsobjektiv hat bei einem verkleinernden Abbildungsmaßstab von 4:1 ($\beta$ = -0,25) eine bildseitige numerische Apertur NA = 0.7 und ist für eine zentrale Arbeitswellenlänge $\lambda$ = 351.1 nm optimiert. Alle Linsen bestehen aus synthetischem Quarzglas, das bei $\lambda$ = 351.1 nm ein Brechungsindex $n_{sio2}$ =1.4767 hat. Die Bildfeldgröße beträgt 26 mm mal 5.5 mm.

Bei der breitbandig abstrahlenden Lichtquelle muss das Projektionsobjektiv dafür ausgelegt sein, die Farbfehler so weit zu reduzieren, dass eine polychromatische Abbildung mit ausreichender Qualität für die lithographische Anwendung realisiert werden kann. In erster Näherung müssen hier vor allem die primären Farbfehler, wie der chromatische Längsfehler (CHL) und der chromatische Vergrößerungsfehler (CHV) korrigiert werden. Zusätzlich sollte der Gaussfehler (chromatische Variation des Öffnungsfehlers) so weit wie möglich minimiert werden. Von großer Bedeutung für die Korrektur der Farbfehler sind vor allem die genutzten Durchmesser des Konkavspiegels CM und der zweifach durchtretenen Zerstreuungslinsen N1 und N2 vor dem Spiegel sowie die Durchmesser der Linsen im hinteren, bildnahen dritten Objektivteil. Diese sind maßgeblich für die Korrektur des chromatischen Längsfehlers. Der chromatische Vergrößerungsfehler CHV wird wesentlich durch die Brechkraftverteilung der Linsen vor und hinter den Pupillenpositionen und durch die geschickte Positionierung der Linsen im Bezug auf die Hauptstrahlhöhen beeinflusst.

Das Projektionsobjektiv 200 ist hervorragend chromatisch korrigiert, wobei CHL = - 0.057 nm/pm, CHV = - 0.009 nm/pm. Der chromatische Defokusfehler beträgt 0 nm/pm. Die bei einem Gesamtsystem mit positiver Brechkraft erforderliche chromatische Überkorrektion findet überwiegend im Bereich der dem Konkavspiegel des zweiten Objektivteils OP2 unmittelbar vorangestellten Negativlinsen N1 und N2 statt, die im Folgenden auch als "Negativgruppe" oder "Schupmannlinsen" bezeichnet werden. Diese sind bei der Ausführungsform hinsichtlich Durchmesser und Brechkraft so dimensioniert, dass die Summe ihrer überkorrigierenden Beiträge zur Farbkorrektur im Wesentlichen gerade die Summe der unterkorrigierenden Beiträge des als Relaissystem dienenden ersten Objektivteils OP1 und des als Fokussierungssystem dienenden, refraktiven dritten Objektivteils OP3 ausgleicht. Dies wird aus Tabelle 2B ersichtlich, die für das Projektionsobjektiv 200 die Beiträge der einzelnen optischen Flächen (Spalte 1) zum Farblängsfehler CHL (Spalte 2) und zum Farbvergrößerungsfehler CHV (Spalte 3) zeigt. Bezeichnet man mit CHLi, i = 1, 2, 3 die Summe der Beiträge des i-ten Objektivteils zum Farblängsfehler und mit CHVi, i = 1, 2, 3 die Summe der entsprechenden Beiträge zum Farbvergrößerungsfehler, so gilt:

CHL1 = - 0.008057;
CHV1 = - 0.004255;
CHL2 = 0.030971;
CHV2 = 0.002446;
CHL3 = - 0.022857;
CHV3 = 0.001818.

Aus den Summen aller Beiträge ergibt sich dabei für den Gesamt-Farblängsfehler CHL = CHL1 + CHL2 + CHL3 = 0.000057 und für die Gesamtsumme der Beiträge zum Farbvergrößerungsfehler CHV = CHV1 + CHV2 + CHV3 = 0.000009. Es werden somit für CHL mehr als 68% der chromatischen Überkorrektur durch die Schuppmannlinsen N1 und N2 geleistet, wodurch der Beitrag aller anderen Teilsysteme weitgehend kompensiert wird.

Dieses Beispiel verdeutlich, dass es bei solchen Systemen nicht erforderlich ist, für die Farbkorrektur Materialien mit unterschiedlicher Dispersion zu verwenden. Dies schließt nicht aus, dass bei Ausführungsformen der Erfindung Linsen mit mindestens zwei unterschiedlichen Materialien verwendet werden können. Beispielsweise kann anstelle einer Linse aus synthetischem Quarzglas eine entsprechende Linse aus dem Spezialglas FK5 verwendet werden, das im Hinblick auf Abbe-Zahl und Dispersion sehr ähnliche optische Eigenschaften (z.B. ca. 3% höhere Dispersion) hat, so dass sich Anordnung und Form der Linsen bei derartigen Varianten nur geringfügig unterscheiden. Die folgenden Überlegungen können bei der Materialauswahl hilfreich sein. Die Abbe-Zahl ν für ein Material mit einer (von der Wellenlänge λ abhängigen) Brechzahl n sei allgemein wie folgt definiert:

$$\nu = \frac{n-1}{n_{\lambda 2} - n_{\lambda 1}},$$

wobei $\lambda_1$ und $\lambda_2 < \lambda_1$ unterschiedliche Wellenlängen sind, die die für die Berechnung der Abbe-Zahl maßgebliche Bandbreite bestimmen. $n_{\lambda 1}$ ist die bei $\lambda_1$ vorliegende Brechzahl. Im Wellenlängenbereich des XeF-Lasers bei ca. 351,1 nm und einer Bandbreite von 1 nm ergibt sich eine Abbe-Zahl ν = 2870 und eine Dispersion $\Delta n = n\lambda_2 - n\lambda_1 = 1.661$ x $10^{-4}$ . Die entsprechend berechneten Werte für FK5 sind beispielsweise: ν = 2956 und $\Delta n = 1.712$ x $10^{-4}$. Zum Vergleich sei noch der entsprechende Wert für Kalziumfluorid ($CaF_2$) angegeben, für das gilt: ν = 3904 und $\Delta n = 1.143$ x $10^{-4}$. Der geringe Dispersionsunterschied zwischen synthetischem Quarzglas und FK5 zeigt, dass diese Materialien im Wesentlichen alternativ in einem System verwendet werden können und dass eine Kombination dieser beiden Materialien keinen nennenswerten Beitrag zur chromatischen Korrektur leisten kann. Eine Kombination Quarzglas oder FK5 mit CaF könnte zwar aufgrund der Dispersionsunterschiede zur chromatischen Korrektur genutzt werden, dies ist aber bei Ausführungsformen der Erfindung nicht erforderlich.

Die Spezifikation für ein anderes, nicht bildlich dargestelltes R-C-R-System mit einem ähnlichen Aufbau wie in Fig. 2 und NA=0.7 ist in den Tabellen 2' und 2'A angegeben. Dieses Projektionsobjektiv ist als i-Linien-Objektiv für eine Arbeitswellenlänge λ = 356,5 ± 2nm ausgelegt und zeichnet sich durch eine chromatische Längsaberration CHL = -0,03 nm/pm und einen Gauss-Fehler von 0,09 nm/pm aus.

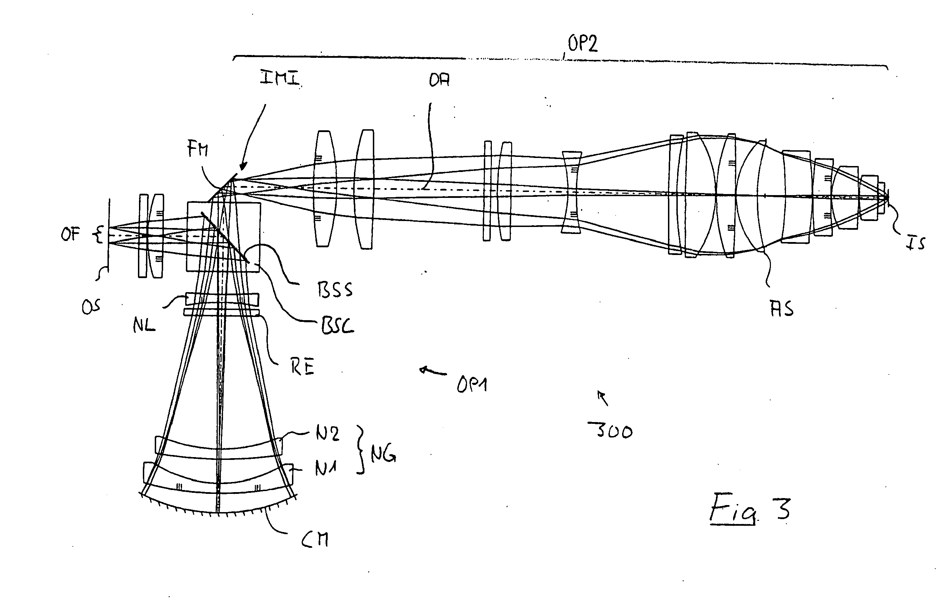

In Fig. 3 ist ein katadioptrisches Projektionsobjektiv 300 mit Polarisationsstrahlteiler (polarization beam splitter) gezeigt, das für eine Arbeitswellenlänge λ = 351.2 nm ± 2 nm ausgelegt ist und dementsprechend alternativ in die mit einem XeF-Laser ausgestattete Projektionsbelichtungsanlage in Fig. 1 eingebaut werden kann. Die Spezifikation dieses "Cube-Designs" ist in Tabellen 3 und 3A angegeben. Das Projektionsobjektiv ist dafür vorgesehen, ein in seiner Objektebene OS angeordnetes Muster einer Maske in reduziertem Maßstab von 4:1 auf seine parallel zur Objektebene ausgerichtete Bildebene IS unter Erzeugung genau eines reellen Zwischenbildes IMI abzubilden. Dabei wird das zentriert um die optische Achse OA angeordnete Objektfeld OF mit Hilfe eines ersten, katadioptrischen Objektivteils OP1 ohne wesentliche Vergrößerung oder Verkleinerung in das Zwischenbild IMI abgebildet, welches durch den nachfolgenden, rein refraktiven zweiten Objektivteil OP2 in verkleinerndem Maßstab von ca. 4:1 in das zentrierte Bilddfeld abgebildet wird. Der erste Objektivteil OP1 enthält einen Konkavspiegel CM mit einer unmittelbar davor angeordneten, aus zwei Negativ-Meniskuslinsen N1 und N2 bestehenden Negativgruppe NG, die einen wesentlichen Anteil der Korrektur der chromatischen Längsaberration bewirkt. Ein physikalischer Strahlteiler BSC mit einer in 45° zur optischen Achse angestellt, polarisationsselektiven Strahlteilerfläche BSS dient dazu, die von der Objektebene OS zum Konkavspiegel CM verlaufende Strahlung von der zwischen dem Konkavspiegel und der Bildfläche verlaufenden Strahlung zu separieren.

Das Projektionsobjektiv wird mit linear polarisierten Licht betrieben, dessen Polarisationsvorzugsrichtung (Schwingungsrichtung des elektrischen Feldvektors) im Strahlengang zwischen der Objektebene OS und dem Strahlteiler BSC zunächst in Bezug auf die Strahlteilerfläche BSS s-polarisiert ist (Schwingungsrichtung des elektrischen Feldvektors senkrecht zur durch die gefaltete optische Achse aufgespannten Einfallsebene), so dass die Strahlung zunächst von der Strahlteilerfläche in Richtung Konkavspiegel reflektiert wird. Zwischen der Strahlteilerfläche und dem Konkavspiegel steht in der Nähe einer Negativlinse NL eine λ/4-Verzögerungsplatte RE, die die durchtretende Strahlung zunächst in zirkular polarisierte Strahlung umwandelt, die auf den Konkavspiegel fällt. Auf dem Rückweg zwischen Konkavspiegel und Strahlteiler wird die λ/4-Platte RE nochmals durchtreten, wodurch die Strahlung in p-polarisierte Strahlung umgewandelt wird, die von der Strahlteilerfläche im Wesentlichen verlustfrei in Richtung des nachgeordneten zweiten Objektivteils OP2 durchgelassen wird. Im Strahlengang unmittelbar hinter dem Strahlteiler BSC ist ein um 90° gegenüber der Strahlteilerfläche angestellter ebener Faltungsspiegel FM vorgesehen, der in Verbindung mit der Strahlteilerfläche dafür sorgt, dass Objektebene und Bildebene parallel zueinander ausgerichtet werden können. Das Zwischenbild entsteht unmittelbar hinter diesem Faltungsspiegel mit optischen Abstand zu diesem, so dass eventuelle Fehler auf der Spiegelfläche die Abbildung nicht spürbar beeinträchtigen. Wie bei der Ausführungsform gemäß Fig. 2 sitzt die verstellbare Aperturblende AS im Endbereich des refraktiven Objektivteils OP2 zwischen dem Bereich maximaler Strahldurchmesser und der Bildebene dort, wo die Strahlung bereits einen deutlich konvergenten Verlauf zur Bildebene IS aufweist.

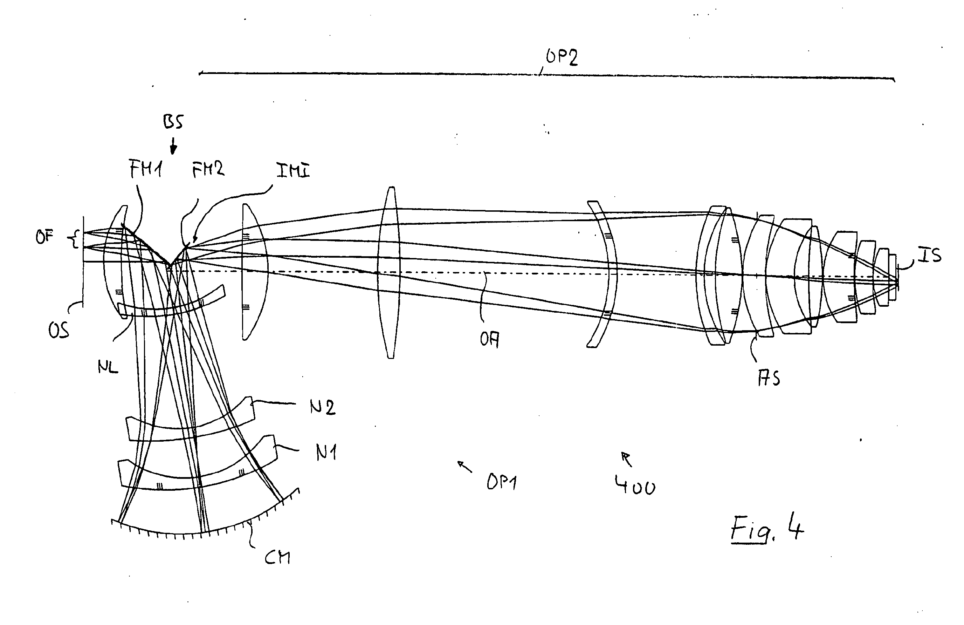

In Fig. 4 ist ein katadioptrisches Projektionsobjektiv 400 gezeigt, das einen geometrischen Strahlteiler BS mit einem bei dieser Faltungsvariante (h-Faltung) konstruktiv notwendigen, ersten, ebenen Faltungsspiegel FM1 sowie einem optionalen, für die Parallelstellung von Objektebene OS und Bildebene IS erforderlichen zweiten Faltungsspiegel FM2 umfasst. Die Spezifikation ist in Tabellen 4 und 4A angegeben. Ein erster, katadioptrischer Objektivteil OP1 mit einem Konkavspiegel CM und einer unmittelbar davor angeordneten Negativgruppe NG mit zwei Negativ-Meniskuslinsen N1 und N2 sowie einer im bereich relativ geringer Randstrahlhöhen angeordneten dünnen Negativ-Meniskuslinse NL mit objektseitiger Konkavfläche bildet das außeraxiale Objektfeld OF mit geringer Verkleinerung in das unmittelbar hinter dem zweiten Faltungsspiegel FM2 liegende einzige Zwischenbild IMI ab, welches durch den refraktiven zweiten Objektivteil OP2 verkleinernd auf die Bildfläche IS abgebildet wird. Das objektseitig und bildseitig telezentrische Projektionsobjektiv hat bei einem verkleinernden Abbildungsmaßstab von 4:1 eine bildseitige numerische Apertur NA = 0.7 und ist für eine zentrale Arbeitswellenlänge λ = 351.2 nm optimiert. Auch hier bestehen alle Linsen aus synthetischem Quarzglas, da die Farbkorrektur, insbesondere von CHL, praktisch ausschließlich durch die dem Konkavspiegel CM vorgeschalteten und im Bereich großer Randstrahlhöhen angeordneten Negativ-Meniskuslinsen N1 und N2 der Negativgruppe NG erzielt werden kann. Damit ist auch bei einer Bandbreite von 200 pm der XeF-Lichtquelle eine Abbildung im Wesentlichen frei von chromatischen Aberrationen möglich.

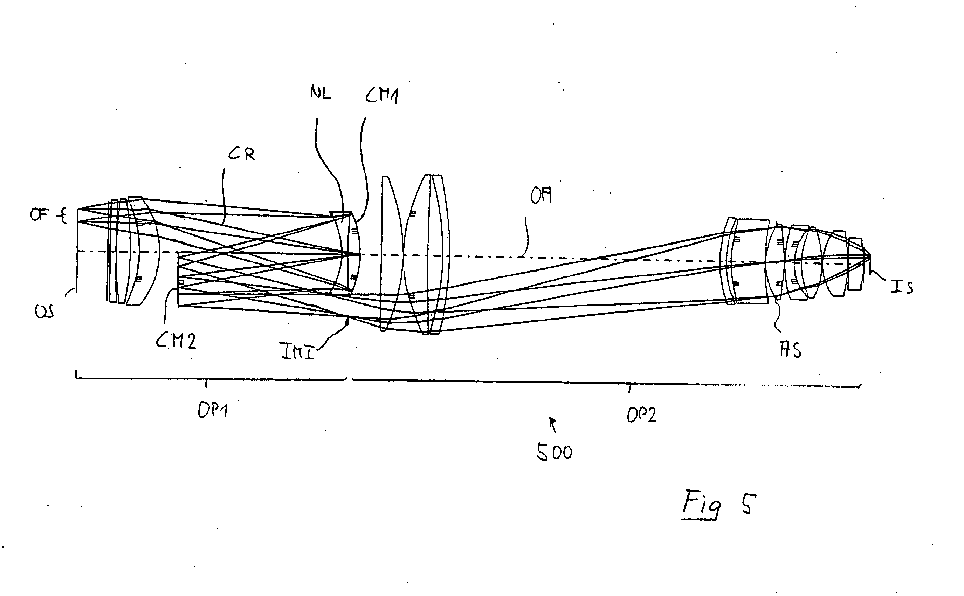

Das in Fig. 5 gezeigte katadioptrische Projektionsobjektiv 500 ist ein Beispiel für ein sog. in-Line-System, bei dem alle optischen Komponenten eine gemeinsame, geradlinig durchgehende (ungefaltete) optische Achse OA besitzen. Die Spezifikation ist in Tabellen 5 und 5A angegeben. Ein erster, katadioptrischer Objektteil OP1 bildet das außeraxiale Objektfeld OF mit leicht vergrößerndem Abbildungsmaßstab in das einzige, reelle Zwischenbild IMI ab, welches mit dem nachfolgenden, rein refraktiven zweiten Objektivteil OP2 in stark verkleinernden Maßstab auf die Bildfläche IS abgebildet wird. Der erste Objektivteil OP1 hat einen ersten Konkavspiegel CM1 mit einer zur Objektebene gewandten, konkaven asphärischen Spiegelfläche, sowie einen geometrisch zwischen dem ersten Konkavspiegel und der Objektfläche angeordneten zweiten Konkavspiegel CM2, dessen asphärische Spiegelfläche der Bildfläche IS zugewandt ist. Der erste Konkavspiegel CM1 sitzt im Bereich der Pupillenfläche P1 des ersten Objektivteils dort, wo der Hauptstrahl CR der Abbildung die optische Achse OA schneidet, er ist somit ein sog. "Pupillenspiegel". Die beleuchtete Fläche des Pupillenspiegels schließt die optische Achse ein. Der für die Reflexion genutzte Bereich des zweiten Konkavspiegels CM2 liegt dagegen geometrisch außerhalb der optischen Achse OA in einem pupillenfernen Bereich, dieser Spiegel wird also ausschließlich außeraxial beleuchtet. Unmittelbar vor dem ersten Konkavspiegel CM1 sitzt eine zweifach durchstrahlte, bikonkave Negativlinse NL, die als pupillennahe Negativgruppe den Hauptteil der chromatischen Korrektur beiträgt.

In Tabelle 6 sind einige wichtige Eigenschaften der hier beispielhaft erläuterten Ausführungsbeispiele zusammenfassend dargestellt. Für jedes Ausführungsbeispiel sind angegeben: die bildseitige numerische Apertur NA, die der Auslegung zugrunde liegende Arbeitswellenlänge λ, der mittlere quadratische Fehler (RMS, root mean square) des Wellenfrontfehlers für die Arbeitswellenlänge, die korrigierte Bandbreite Δλ, der gemittelte Wellenfrontfehler $RMS_{poly}$ für die gesamte genutzte Bandbreite, die chromatische Längsaberration CHL, der Gauss-Fehler GF, der Durchmesser DS des Konkavspiegels, der Durchmesser DL der größten Linse, und die "track length" TL, d.h. der axiale Abstand zwischen Objektebene und Bildebene.

An den sehr geringen Werten für CHL und GF ist erkennbar, dass die Projektionsobjektive für die breitbandige Anwendung hervorragend chromatisch korrigiert sind. Die Maße für die Durchmesser der Konkavspiegel und der größten Linsen zeigen, dass es durch die Verwendung katadioptrischer Projektionsobjektive möglich ist, relativ schlanke Systeme mit moderaten Linsendurchmessern aufzubauen, wodurch auc Linsenmaterial sparsam eingesetzt wird. Es ist möglich, diese praktischen Vorteile zu erzielen, ohne das ggf. begrenzt verfügbare Spezialgläser für die Farbkorrektur verwendet werden müssen. Alle Ausführungsbeispiele sind ausschließlich mit Linsen aus synthetischem Quarzglas aufgebaut, das in großem Umfang mit hoher Qualität verfügbar ist.

**Tabelle 2**

| Fläche | Radien | | Dicken | Material | Brechzahl | Linsenhöhe | |
|--------|--------|---|--------|----------|-----------|------------|---|
| | | | | | | | |
| 0 | 0 | | 172.177 | | | 62.00 | |
| 1 | 0 | | 0 | SIO2 | 1.476714 | 92.61 | |
| 2 | 0 | | 0 | | | 92.61 | |
| 3 | 350.64 | | 29.318 | SIO2 | 1.476714 | 94.94 | |
| 4 | -739.523 | | 3.791 | | | 95.19 | |
| 5 | 299.134 | AS | 25.622 | SIO2 | 1.476714 | 94.65 | |
| 6 | -1117.15 | | 45.75 | | | 93.95 | |
| 7 | 335.156 | | 31.731 | SIO2 | 1.476714 | 85.10 | |
| 8 | -336.974 | | 50.611 | | | 83.21 | |

(fortgesetzt)

| Fläche | Radien | | Dicken | Material | Brechzahl | Linsenhöhe | |
|---|---|---|---|---|---|---|---|
| 9 | 474.305 | | 40.001 | SIO2 | 1.476714 | 54.95 | |
| 10 | 106.336 | AS | 70.123 | | | 40.54 | |
| 11 | -113.666 | | 10.241 | SIO2 | 1.476714 | 47.51 | |
| 12 | 1098.388 | | 16.944 | | | 57.21 | |
| 13 | -165.489 | | 35.001 | SIO2 | 1.476714 | 60.42 | |
| 14 | -101.843 | | 18.772 | | | 71.49 | |
| 15 | -668.042 | | 49.67 | SIO2 | 1.476714 | 92.84 | |
| 16 | -124.464 | | 32.117 | | | 96.67 | |
| 17 | 738.862 | | 35.208 | SIO2 | 1.476714 | 101.35 | |
| 18 | -290.918 | | 8.151 | | | 101.27 | |
| 19 | 245.453 | | 28.949 | SIO2 | 1.476714 | 92.42 | |
| 20 | -2112.418 | AS | 109.419. | | | 89.77 | |
| 21 | 0 | | 38.969 | | | 44.97 | |
| 22 | 0 | | 244.904 | | | 41.55 | Spiegel |
| 23 | -123.1 | AS | 24.953 | SIO2 | 1.476714 | 74.99 | |
| 24 | -2299.124 | | 92.576 | | | 89.16 | |
| 25 | -157.433 | | 25.003 | SIO2 | 1.476714 | 114.03 | |
| 26 | -336.506 | | 46.754 | | | 146.81 | |
| 27 | 0 | | 0 | | | 229.53 | |
| 28 | 246.613 | | 46.754 | | | 164.70 | Spiegel |
| 29 | 336.506 | | 25.003 | SIO2 | 1.476714 | 149.91 | |
| 30 | 157.433 | | 92.576 | | | 119.48 | |
| 31 | 2299.124 | | 24.953 | SIO2 | 1.476714 | 99.44 | |
| 32 | 123.1 | AS | 244.904 | | | 82.15 | |
| 33 | 0 | | 0.001 | | | 46.20 | |
| 34 | 0 | | 38.969 | | | 46.20 | Spiegel |
| 35 | 0 | | 101.931 | | | 44.75 | |
| 36 | 898.72 | | 28.595 | SIO2 | 1.476714 | 84.33 | |
| 37 | -390.372 | | 0.999 | | | 87.41 | |
| 38 | 222.538 | | 36.092 | SIO2 | 1.476714 | 93.71 | |
| 39 | -813.695 | | 0.998 | | | 93.47 | |
| 40 | 272.095 | | 38.915 | SIO2 | 1.476714 | 91.46 | |
| 41 | -6381.92 | | 69.266 | | | 87.53 | |
| 42 | -157.225 | AS | 20 | SIO2 | 1.476714 | 73.39 | |
| 43 | 134.403 | | 121.23 | | | 72.54 | |
| 44 | 846.914 | AS | 44.598 | SIO2 | 1.476714 | 109.38 | |
| 45 | -264.134 | | 31.943 | | | 110.77 | |
| 46 | 847.33 | | 25.244 | SIO2 | 1.476714 | 109.86 | |

(fortgesetzt)

| Fläche | Radien | | Dicken | Material | Brechzahl | Linsenhöhe | |
|---|---|---|---|---|---|---|---|
| 47 | -748.803 | | 1.006 | | | 109.34 | |
| 48 | 209.64 | | 27.45 | SIO2 | 1.476714 | 103.87 | |
| 49 | 578.997 | AS | 60.305 | | | 101.07 | |
| 50 | 0 | | -21.802 | | | 85.90 | |
| 51 | 150.184 | | 22.033 | SIO2 | 1.476714 | 85.40 | |
| 52 | 241.425 | | 32.307 | | | 82.90 | |
| 53 | -256.952 | | 10.083 | SIO2 | 1.476714 | 82.09 | |
| 54 | 357.45 | | 34.614 | | | 81.55 | |
| 55 | 306.754 | | 28.814 | SIO2 | 1.476714 | 84.84 | |
| 56 | -568.358 | | 1.342 | | | 84.48 | |
| 57 | 218.878 | | 25.031 | SIO2 | 1.476714 | 81.59 | |
| 58 | 3829.622 | | 0.984 | | | 79.47 | |
| 59 | 138.938 | | 22.982 | SIO2 | 1.476714 | 73.03 | |
| 60 | 404.372 | AS | 5.589 | | | 68.80 | |
| 61 | 131.519 | | 34.806 | SIO2 | 1.476714 | 62.87 | |
| 62 | 469.69 | | 0.998 | | | 52.49 | |
| 63 | 202.542 | | 34.732 | SIO2 | 1.476714 | 49.51 | |
| 64 | 0 | | 19 | | | 34.12 | |

## Tabelle 2A

| Asphärische Konstanten | | | | | |
|---|---|---|---|---|---|
| | | | | | |
| Fläche | | 10 | 20 | 23 | 32 |
| K | 0 | 0 | 0 | 0 | 0 |
| C1 | -4.02E-08 | -1.31 E-07 | 1.72E-08 | 5.56E-08 | -5.56E-08 |
| C2 | -7.29E-13 | -1.14E-10 | -2.05E-13 | 1.30E-12 | -1.30E-12 |
| C3 | 1.55E-18 | -1.00E-15 | 7.65E-18 | -6.06E-18 | 6.06E-18 |
| C4 | -2.40E-23 | 6.39E-19 | -6.70E-22 | 2.27E-21 | -2.27E-21 |
| C5 | 4.37E-26 | -7:88E-24 | 7.29E-26 | -1.37E-24 | 1.37E-24 |
| C6 | -2.79E-30 | 5.08E-27 | -3.82E-30 | 1.36E-28 | -1.36E-28 |
| | | | | | |
| Fläche | 42 | 44 | 49 | 60 | |
| K | 0 | 0 | 0 | 0 | |
| C1 | -1.02E-08 | 3.06E-08 | 1.87E-08 | 1.15E-07 | |
| C2 | 7.94E-12 | -1.43E-12 | -7.80E-13 | -2.74E-12 | |
| C3 | -3.21 E-16 | 6.47E-17 | 7.92E-18 | 5.33E-16 | |
| C4 | 4.34E-21 | -9.39E-22 | 8.08E-22 | -1.24E-19 | |

(fortgesetzt)

| Fläche | 42 | 44 | 49 | 60 | |
|---|---|---|---|---|---|
| C5 | -1.72E-25 | -1.07E-26 | -6.91 E-26 | 1.80E-23 | |
| C6 | 6.17E-29 | 7.29E-33 | 4.52E-30 | -8.26E-28 | |

**Tabelle 2'**

| Fläche | Radien | | Dicken | Material | Brechzahl 365 nm | Linsenhöhe | |
|---|---|---|---|---|---|---|---|
| 0 | 0.000 | | 176.827 | | | 54.41 | |
| 1 | 0.000 | | 0.000 | SIO2 | 1.474564 | 82.013 | |
| 2 | 0.000 | | 0.000 | | | 82.013 | |
| 3 | -19718.367 | | 23.128 | SIO2 | 1.474564 | 81.985 | |
| 4 | -292.102 | | 28.328 | | | 83.236 | |
| 5 | 800.830 | AS | 15.158 | SIO2 | 1.474564 | 84.347 | |
| 6 | -1042.540 | | 56.841 | | | 84.673 | |
| 7 | -865.161 | | 28.942 | SIO2 | 1.474564 | 85.24 | |
| 8 | -185.806 | | 101.236 | | | 85.726 | |
| 9 | 72.230 | | 33.701 | SIO2 | 1.474564 | 56.402 | |
| 10 | 90.972 | AS | 88.997 | | | 47.622 | |
| 11 | -54.979 | | 15.063 | SIO2 | 1.474564 | 37.032 | |
| 12 | 1581.978 | | 13.029 | | | 47.674 | |
| 13 | -176.374 | | 34.998 | SIO2 | 1.474564 | 50.603 | |
| 14 | -102.728 | | 2.196 | | | 61.477 | |
| 15 | -2171.621 | | 42.619 | SIO2 | 1.474564 | 69.886 | |
| 16 | -122.816 | | 1.001 | | | 74.794 | |
| 17 | 697.014 | | 29.577 | SIO2 | 1.474564 | 76.474 | |
| 18 | -223.054 | | 1.000 | | | 76.502 | |
| 19 | 283.360 | | 22.253 | SIO2 | 1.474564 | 72.25 | |
| 20 | -956.384 | AS | 87.120 | | | 70.02 | |
| 21 | 0.000 | | 302.696 | | | 62.46 | Spiegel |
| 22 | 143.355 | AS | 16.736 | SIO2 | 1.474564 | 77.376 | |
| 23 | 2480.121 | | 81.893 | | | 87.983 | |
| 24 | 147.470 | | 14.584 | SIO2 | 1.474564 | 105.134 | |
| 25 | 368.278 | | 43.425 | | | 126.691 | |
| 26 | 221.491 | | 43.425 | | | 138.954 | Spiegel |
| 27 | 368.278 | | 14.584 | SIO2 | 1.474564 | 125.148 | |
| 28 | 147.470 | | 81.893 | | | 104.295 | |
| 29 | 2480.121 | | 16.736 | SIO2 | 1.474564 | 87.434 | |
| 30 | 143.355 | AS | 302.696 | | | 77.156 | |
| 31 | 0.000 | | 51.133 | | | 55.769 | Spiegel |

(fortgesetzt)

| Fläche | Radien | | Dicken | Material | Brechzahl 365 nm | Linsenhöhe | |
|---|---|---|---|---|---|---|---|
| 32 | -200.976 | | 21.420 | SIO2 | 1.474564 | 56.674 | |
| 33 | 680.135 | | 11.152 | | | 57.805 | |
| 34 | -562.432 | | 17.682 | SIO2 | 1.474564 | 59.753 | |
| 35 | 562.830 | | 47.790 | | | 60.252 | |
| 36 | -236.854 | | 40.000 | SIO2 | 1.474564 | 61.367 | |
| 37 | -1546.424 | | 18.936 | | | 59.066 | |
| 38 | 156.229 | AS | 10.013 | SIO2 | 1.474564 | 58.619 | |
| 39 | -226.425 | | 139.573 | | | 61.579 | |
| 40 | -568.261 | AS | 44.696 | SIO2 | 1.474564 | 105.078 | |
| 41 | 279.788 | | 174.740 | | | 106.637 | |
| 42 | -195.077 | | 40.133 | SIO2 | 1.474564 | 105.278 | |
| 43 | 6098.289 | AS | 42.766 | | | 103.174 | |
| 44 | 0.000 | | 21.290 | | | 91.903 | |
| 45 | -170.175 | | 26.099 | SIO2 | 1.474564 | 91.33 | |
| 46 | -378.312 | | 26.006 | | | 88.623 | |
| 47 | 344.391 | | 15.107 | SIO2 | 1.474564 | 87.435 | |
| 48 | 4548.401 | | 62.468 | | | 85.019 | |
| 49 | -966.806 | | 21.276 | SIO2 | 1.474564 | 75.29 | |
| 50 | 511.375 | | 1.000 | | | 73.693 | |
| 51 | -209.251 | | 22.697 | SIO2 | 1.474564 | 69.003 | |
| 52 | 1404.235 | AS | 1.000 | | | 65.971 | |
| 53 | -80.965 | | 29.116 | SIO2 | 1.474564 | 55.695 | |
| 54 | -298.685 | | 6.479 | | | 49.332 | |
| 55 | -545.144 | | 29.986 | SIO2 | 1.474564 | 45.65 | |
| 56 | 0.000 | | 19.000 | | | 30.798 | |
| 57 | 0.000 | | 0.000 | | | 13.603 | |

### Tabelle 2'A

| Asphärische Konstanten | | | | |
|---|---|---|---|---|
| Fläche | 5 | 10 | 20 | 22 |
| K | 0.00000E+00 | 0.00000E+00 | 0 | 0 |
| C1 | -5.02585E-08 | -1.38515E-07 | 2.53159E-08 | -4.67926E-08 |
| C2 | -9.06925E-13 | -5.84508E-11 | -2.30376E-13 | 3.00852E-13 |
| C3 | -1.00335E-17 | 1.96118E-15 | 1.38762E-17 | 1.20999E-17 |
| C4 | -2.61387E-22 | 5.20762E-19 | -1.93621 E-21 | 1.84312E-20 |
| C5 | 1.82082E-27 | -1.83546E-23 | 3.23365E-25 | -2.22528E-24 |
| C6 | 1.50365E-31 | 5.52136E-27 | -1.88062E-29 | 2.1258E-28 |

(fortgesetzt)

| Fläche | 30 | 38 | 40 | 43 |
|---|---|---|---|---|
| K | 0 | 0 | 0 | -2.17146E-08 |
| C1 | -4.67926E-08 | 9.6521E-08 | -1.73748E-08 | 1.96262E-13 |
| C2 | 3.00852E-13 | -3.5021E-12 | 7.94003E-13 | 8.09633E-18 |
| C3 | 1.20999E-17 | -1.33753E-16 | -1.51295E-17 | 1.56848E-22 |
| C4 | 1.84312E-20 | 6.03955E-21 | -5.11214E-23 | -6.34275E-27 |
| C5 | -2.22528E-24 | -2.23825E-24 | 2.46994E-26 | 4.16085E-32 |
| C6 | 2.1258E-28 | 2.14956E-28 | -1.0035E-30 | -2.17146E-08 |
| **Fläche** | **52** | | | |
| K | 0 | | | |
| C1 | -6:80169E-08 | | | |
| C2 | 3.27923E-12 | | | |
| C3 | -3.77619E-16 | | | |
| C4 | 3.98285E-20 | | | |
| C5 | -2.06995E-24 | | | |
| C6 | 5.4894E-29 | | | |

**Tabelle 2B**

| Fläche | CHL | CHV | CHL-Teilsysteme | CHV-Teilsysteme | |
|---|---|---|---|---|---|
| 1 | -0.000611 | -3.07E-05 | | | |
| 2 | 0.000611 | 3.07E-05 | | | |
| | | | | | |
| 3 | -0.000911 | 0.000562 | | | |
| 4 | 0.00026 | 0.000779 | | | |
| | | | | | |
| 5 | -0.000862 | 0.000248 | | | |
| 6 | 5.81E-05 | 0.001146 | | | |
| | | | | | |
| 7 | -0.000647 | -0.000481 | | | |
| 8 | -0.000692 | 0.001925 | | | |
| | | | | | |
| 9 | -4.85E-05 | -0.001211 | | | |
| 10 | 0.001203 | 0.000921 | | | |
| | | | | | |
| 11 | 0.001 | -0.000788 | | | |
| 12 | 0.000977 | 0.001736 | | | |
| | | | | | |

(fortgesetzt)

| Fläche | CHL | CHV | CHL-Teilsysteme | CHV-Teilsysteme | |
|---|---|---|---|---|---|
| 13 | 0.000133 | -0.001152 | | | |
| 14 | -0.001915 | -0.00026 | | | |
| | | | | | |
| 15 | -0.000156 | -0.001373 | | | |
| 16 | -0.003016 | -0.001815 | | | |
| | | | | | |
| 17 | -5.12E-06 | -0.001243 | | | |
| 18 | -0.001934 | -0.001168 | | | |
| | | | | | |
| 19 | -6.08E-05 | -0.001315 | | | |
| 20 | -0.001441 | -0.000766 | | | |
| | | | -0.008057 | -0.004255 | Relaysystem OP1 |
| 23 | 0.002201 | -0.001424 | | | |
| 24 | 0.004466 | 0.001008 | | | |
| | | | | | |
| 25 | 0.004054 | -0.001039 | | | |
| 26 | 0.004764 | 0.001518 | | | |
| | | | | | |
| 29 | 0.004763 | -0.000766 | | | |
| 30 | 0.004055 | 0.001679 | | | |
| | | | | | |
| 31 | 0.004466 | -0.000303 | | | |
| 32 | 0.002202 | 0.001773 | | | |
| | | | 0.030971 | 0.002446 | Schupmannlinsen |
| 36 | -0.001478 | 0.000657 | | | |
| 37 | 0.000468 | 0.000693 | | | |
| | | | | | |
| 38 | -0.002095 | 0.001189 | | | |
| 39 | 0.000128 | 0.001105 | | | |
| | | | | | |
| 40 | -0.001402 | 0.000207 | | | |
| 41 | -6.88E-05 | 0.001299 | | | |
| | | | | | |
| 42 | 0.001654 | -0.002182 | | | |
| 43 | 0.003812 | -0.000701 | | | |
| | | | | | |
| 44 | -0.004134 | -0.000403 | | | |

(fortgesetzt)

| Fläche | CHL | CHV | CHL-Teilsysteme | CHV-Teilsysteme | |
|---|---|---|---|---|---|
| 45 | -0.002907 | 0.001709 | | | |
| | | | | | |
| 46 | -0.002326 | -0.000946 | | | |
| 47 | -0.001775 | 0.001425 | | | |
| | | | | | |
| 48 | -0.005007 | -0.000712 | | | |
| 49 | -0.000112 | 0.001247 | | | |
| | | | | | |
| 51 | -0.004075 | -0.001105 | | | |
| 52 | 0.000397 | 0.001233 | | | |
| | | | | | |
| 53 | 0.004618 | -0.000999 | | | |
| 54 | 0.00105 | 0.001307 | | | |
| | | | | | |
| 55 | -0.001211 | -0.001413 | | | |
| 56 | -0.002494 | 0.000755 | | | |
| | | | | | |
| 57 | -0.000505 | -0.001337 | | | |
| 58 | -0.00227 | 0.000679 | | | |
| | | | | | |
| 59 | -0.000382 | -0.001332 | | | |
| 60 | -0.002109 | 0.000586 | | | |
| | | | | | |
| 61 | 0.00077 | -0.000979 | | | |
| 62 | -0.00199 | 0.000211 | | | |
| | | | | | |
| 63 | 0.001665 | -0.000359 | | | |
| 64 | -0.001078 | -1.59E-05 | | | |
| | | | -0.022857 | 0.001818 | Fokusgruppe OP3 |
| SUM | 0.000057 | 0.000009 | | | |
| | | | 0.000057 | 0.000009 | Summe |

### Tabelle 3

| Fläche | Radien | | Dicken | Material | Brechzahl 351.2nm | Linsenhöhe | |
|---|---|---|---|---|---|---|---|
| 0 | 0 | | 45 | | | 53.2 | |
| 1 | 0 | | 0 | | | 61.041 | |
| 2 | 0.000 | | 0.000 | SIO2 | 1:476714 | 61.041 | |

(fortgesetzt)

| Fläche | Radien | | Dicken | Material | Brechzahl 351.2nm | Linsenhöhe | |
|---|---|---|---|---|---|---|---|
| 3 | 0.000 | | 0.000 | | | 61.041 | |
| 4 | 0.000 | | 12.000 | SIO2 | 1.476714 | 61.041 | |
| 5 | 0.000 | | 0.998 | | | 62.45 | |
| 6 | 197.629 | | 22.557 | SIO2 | 1.476714 | 64.519 | |
| 7 | -2180.107 | AS | 38.334 | | | 64.537 | |
| 8 | 0.000 | | 50.000 | SIO2 | 1.476714 | 64.073 | |
| 9 | 0.000 | | 0.000 | SIO2 | 1.476714 | 64.372 | Spiegel |
| 10 | 0.000 | | 50.000 | SIO2 | 1.476714 | 63.692 | |
| 11 | 0.000 | | 33.702 | | | 63.329 | |
| 12 | 829.066 | | 12.500 | SIO2 | 1.476714 | 63.008 | |
| 13 | -334.986 | AS | 10.000 | | | 63.405 | |
| 14 | 0.000 | | 10.000 | SIO2 | 1.476714 | 63.846 | |
| 15 | 0.000 | | 193.193 | | | 64.934 | |
| 16 | 225.193 | | 15.000 | SIO2 | 1.476714 | 93.091 | |
| 17 | 546.903 | | 35.135 | | | 99.681 | |
| 18 | 177.821 | | 15.000 | SIO2 | 1.476714 | 102.968 | |
| 19 | 432.528 | AS | 29.297 | | | 115.815 | |
| 20 | 245.035 | | 29.297 | | | 122.059 | Spiegel |
| 21 | 432.528 | AS | 15.000 | SIO2 | 1.476714 | 113.264 | |
| 22 | 177.821 | | 35.135 | | | 97.674 | |
| 23 | 546.903 | | 15.000 | SIO2 | 1.476714 | 90.88 | |
| 24 | 225.193 | | 193.193 | | | 82.066 | |
| 25 | 0.000 | | 10.000 | SIO2 | 1.476714 | 54.099 | |
| 26 | 0.000 | | 10.000 | | | 53.251 | |
| 27 | -334.986 | AS | 12.500 | SIO2 | 1.476714 | 52.587 | |
| 28 | 829.066 | | 33.702 | | | 52.253 | |
| 29 | 0.000 | | 100.000 | SIO2 | 1.476714 | 52.398 | |
| 30 | 0.000 | | 22.857 | | | 52.796 | |
| 31 | 0.000 | | 0.000 | | | 54.007 | Spiegel |
| 32 | 0.000 | | 24.966 | | | 52.958 | |
| 33 | 0.000 | | 107.553 | | | 53.15 | |
| 34 | -484.601 | AS | 34.970 | SIO2 | 1.476714 | 92.021 | |
| 35 | 318.238 | | 25.499 | | | 94.281 | |
| 36 | -296.856 | | 29.865 | SIO2 | 1.476714 | 101.082 | |
| 37 | 2569.143 | | 165.796 | | | 100.689 | |
| 38 | 0.000 | | 10.000 | SIO2 | 1.476714 | 87.96 | |
| 39 | 0.000 | | 10.000 | | | 87.45 | |
| 40 | -338.306 | | 20.935 | SIO2 | 1.476714 | 85.862 | |

(fortgesetzt)

| Fläche | Radien | | Dicken | Material | Brechzahl 351.2nm | Linsenhöhe | |
|---|---|---|---|---|---|---|---|
| 41 | 11541.440 | | 84.712 | | | 84.574 | |
| 42 | 192.059 | | 12.500 | SIO2 | 1.476714 | 69.849 | |
| 43 | -261.087 | AS | 138.444 | | | 69.699 | |
| 44 | -2435.383 | | 12.500 | SIO2 | 1.476714 | 92.516 | |
| 45 | -445.214 | | 12.873 | | | 94.737 | |
| 46 | -3613.384 | | 44.766 | SIO2 | 1.476714 | 95.825 | |
| 47 | 159.106 | | 0.996 | | | 97.572 | |
| 48 | -252.041 | | 28.696 | SIO2 | 1.476714 | 92.106 | |
| 49 | 1599.354 | AS | 0.995 | | | 90.188 | |
| 50 | -114.974 | | 31.350 | SIO2 | 1.476714 | 79.689 | |
| 51 | -272.910 | | 11.343 | | | 74.939 | |
| 52 | 0.000 | | 29.661 | | | 74.432 | |
| 53 | 421.975 | | 39.963 | SIO2 | 1.476714 | 66.554 | |
| 54 | 443.498 | | 1.000 | | | 60.182 | |
| 55 | -563.370 | | 26.795 | SIO2 | 1.476714 | 57.694 | |
| 56 | -937.891 | AS | 0.998 | | | 51.271 | |
| 57 | -94.594 | | 39.953 | SIO2 | 1.476714 | 48.373 | |
| 58 | 494.747 | | 0.993 | | | 39.382 | |
| 59 | -174.856 | | 27.718 | SIO2 | 1.476714 | 35.393 | |
| 60 | 268.569 | | 1.220 | | | 24.296 | |
| 61 | 0.000 | | 10.000 | SIO2 | 1.476714 | 24.412 | |
| 62 | 0.000 | | 5.984 | | | 19.074 | |
| 63 | 0.000 | | 0.000 | | | 13.3 | |

**Tabelle 3A**

| Asphärische Konstanten | | | | |
|---|---|---|---|---|
| Fläche | 7 | 13 | 19 | 21 |
| K | 0.00000E+00 | 0.00000E+00 | 0.00000E+00 | 0 |
| C1 | -2.17433E-09 | -7.34506E-08 | 5.09422E-09 | 5.09422E-09 |
| C2 | 2.17097E-13 | -1.61389E-14 | 2.73779E-14 | 2.73779E-14 |
| C3 | -5.02694E-17 | -8.54786E-17 | -3.12207E-18 | -3.12207E-18 |
| C4 | 2.29688E-20 | -1.52633E-20 | -1.04920E-23 | -1.0492E-23 |
| C5 | -4,67889E-24 | 3.81619E-24 | 1.07727E-27 | 1.07727E-27 |
| C6 | 3.76978E-28 | -4.38758E-28 | 2.13340E-31 | 2.1334E-31 |
| Fläche | 27 | 34 | 43 | 49 |
| K | 0 | 0 | 0 | 0 |
| C1 | -7.34506E-08 | 1.128E-08 | -4.61047E-08 | -1.93871 E-08 |

(fortgesetzt)

| Fläche | 27 | 34 | 43 | 49 |
|--------|-----|-----|-----|-----|
| C2 | -1.61389E-14 | -9.03612E-14 | -2.35243E-12 | -1.32409E-14 |
| C3 | -8.54786E-17 | 3.2584E-18 | -1.23627E-17 | 4.410711E-17 |
| C4 | -1.52633E-20 | -6.74012E-22 | 1.29558E-20 | -8.50818E-22 |
| C5 | 3.81619E-24 | 6.80863E-26 | -4.48348E-24 | 2.73476E-25 |
| C6 | -4.38758E-28 | -2.63841 E-30 | 3.63347E-28 | -2.16104E-29 |
| Fläche | 56 | | | |
| K | 0 | | | |
| C1 | -1.55272E-07 | | | |
| C2 | -2.23849E-11 | | | |
| C3 | -1.727E-15 | | | |
| C4 | 4.99134E-20 | | | |
| C5 | -8.04316E-23 | | | |
| C6 | -1.62598E-27 . | | | |

**Tabelle 4**

| Fläche | Radien | | Dicken | Material | Brechzahl 351.2nm | Linsenhöhe | |
|--------|--------|-----|--------|----------|-------------------|------------|-----|
| | | | | | | | |
| 0 | 0 | | 30 | | | 67 | |
| 1 | 135.461 | | 25.972 | SIO2 | 1.476714 | 74.437 | |
| 2 | 426.296 | AS | 64.637 | | | 73.171 | |
| 3 | 0.000 | | 0.000 | | | 94.15 | Spiegel |
| 4 | 0.000 | | 67.937 | | | 69.564 | |
| 5 | 155.665 | | 9.998 | SIO2 | 1.476714 | 66.722 | |
| 6 | 215.575 | AS | 168.338 | | | 68.451 | |
| 7 | 131.432 | | 15.000 | SIO2 | 1.476714 | 76.132 | |
| 8 | 373.137 | | 58.764 | | | 83.834 | |
| 9 | 142.141 | | 15.000 | SIO2 | 1.476714 | 93.077 | |
| 10 | 325.833 | AS | 67.311 | | | 107.044 | |
| 11 | 251.578 | | 67.311 | | | 131.109 | Spiegel |
| 12 | 325.833 | AS | 15.000 | SIO2 | 1.476714 | 97.382 | |
| 13 | 142.141 | | 58.764 | | | 82.204 | |
| 14 | 373.137 | | 15.000 | SIO2 | 1.476714 | 67.576 | |
| 15 | 131.432 | | 168.338 | | | 62.097 | |
| 16 | 215.575 | AS | 9.998 | SIO2 | 1.476714 | 52.689 | |
| 17 | 155.665 | | 54.070 | | | 51.478 | |
| 18 | 0.000 | | 24.992 | | | 62.432 | Spiegel |
| 19 | 0.000 | | 86.593 | | | 54.218 | |

(fortgesetzt)

| Fläche | Radien | | Dicken | Material | Brechzahl 351.2nm | Linsenhöhe | |
|---|---|---|---|---|---|---|---|
| 20 | -1368.981 | AS | 38.820 | SIO2 | 1.476714 | 87.081 | |
| 21 | 172.778 | | 162.821 | | | 90.099 | |
| 22 | -462.445 | | 33.173 | SIO2 | 1.476714 | 112.042 | |
| 23 | 901.139 | | 314.046 | | | 111.975 | |
| 24 | 186.346 | | 12.500 | SIO2 | 1.476714 | 93.887 | |
| 25 | 189.668 | AS | 116.940 | | | 95.931 | |
| 26 | -240.339 | | 12.500 | SIO2 | 1.476714 | 93.612 | |
| 27 | -172.282 | | 16.559 | | | 90.886 | |
| 28 | -309.749 | | 39.642 | SIO2 | 1.476714 | 91.266 | |
| 29 | 249.695 | AS | 21.749 | | | 90.824 | |
| 30 | 0.000 | | 20.755 | | | 82.563 | |
| 31 | -166.632 | | 33.602 | SIO2 | 1.476714 | 82.59 | |
| 32 | -300.290 | | 0.990 | | | 78.619 | |
| 33 | -147.436 | | 41.674 | SIO2 | 1.476714 | 76.98 | |
| 34 | -120.561 | | 21.313 | | | 65.962 | |
| 35 | -745.951 | | 20.036 | SIO2 | 1.476714 | 65.457 | |
| 36 | 309.759 | | 0.979 | | | 64.388 | |
| 37 | -117.313 | | 45.502 | SIO2 | 1.476714 | 58.23 | |
| 38 | -350.236 | AS | 0.968 | | | 46.64 | |
| 39 | -165.648 | | 26.051 | SIO2 | 1.476714 | 44.5 | |
| 40 | -268.723 | | 0.930 | | | 35.355 | |
| 41 | -100.751 | | 23.326 | SIO2 | 1.476714 | 33.022 | |
| 42 | 494.236 | | 0.238 | | | 24.919 | |
| 43 | 0.000 | | 10.000 | SIO2 | 1.476714 | 24.572 | |
| 44 | 0.000 | | 3.868 | | | 19.842 | |
| 45 | 0.000 | | 0.000 | | | 16.75 | |

**Tabelle 4A**

| Asphärische Konstanten | | | | |
|---|---|---|---|---|
| Fläche | 2 | 6 | 10 | 12 |
| K | 0.00000E+00 | 0.00000E+00 | 0.00000E+00 | 0.00000E+00 |
| C1 | 2.95478E-08 | -2.16063E-08 | 3.40020E-09 | 3.40020E-09 |
| C2 | 5.92986E-13 | -4.40446E-13 | -1.14329E-13 | -1.14329E-13 |
| C3 | -1.36196E-16 | -1.26694E-16 | 5.27453E-18 | 5.27453E-18 |
| C4 | 1.30888E-20 | 1.70446E-20 | -2.27607E-22 | -2.27607E-22 |
| C5 | -1.63022E-24 | -4.20741 E-24 | 5.90958E-27 | 5.90958E-27 |
| C6 | 9.45001 E-29 | 1.90971 E-28 | -3.75640E-31 | -3.75640E-31 |

(fortgesetzt)

| Fläche | 16 | 20 | 25 | 29 |
|--------|-----|-----|-----|-----|
| K | 0.00000E+00 | 0.00000E+00 | 0.00000E+00 | 0.0000E+00 |
| C1 | -2.16063E-08 | 2.01107E-08 | -2.54292E-08 | -2.63649E-08 |
| C2 | -4.40446E-13 | -4.28089E-13 | 4.52099E-13 | 4.30333E-14 |
| C3 | -1.26694E-16 | 2.08780E-17 | -1.32715E-17 | -1.17254E-17 |
| C4 | 1.70446E-20 | -1.50708E-21 | 7.76316E-22 | 9.80725E-22 |
| C5 | -4.20741 E-24 | 1.37439E-25 | -9.75510E-27 | -6.40999E-26 |
| C6 | 1.90971 E-28 | -6.51446E-30 | -6.06816E-31 | 3.89136E-30 |
| Fläche | 38 | | | |
| K | 0.00000E+00 | | | |
| C1 | 1.30968E-07 | | | |
| C2 | -2.00191 E-11 | | | |
| C3 | 2.04819E-15 | | | |
| C4 | -4.86180E-19 | | | |
| C5 | 8.83291 E-23 | | | |
| C6 | -8.36889E-27 | | | |

**Tabelle 5**

| Fläche | Radien | | Dicken | Material | Brechzahl | Linsenhöhe | |
|--------|--------|---|--------|----------|-----------|------------|---|
| | | | | | | | |
| 0 | 0 | | 53.194538 | | | 68 | |
| 1 | 3800.134 | | 10.000 | SIO2 | 1.476665 | 78.142 | |
| 2 | 1922.352 | | 0.998 | | | 79.433 | |
| 3 | 662.532 | | 22.138 | SIO2 | 1,476665 | 80.274 | |
| 4 | -460.290 | | 14.441 | | | 81.195 | |
| 5 | -201.533 | AS | 32.622 | SIO2 | 1.476665 | 81.398 | |
| 6 | -142.141 | | 293.887 | | | 85.338 | |
| 7 | -121.656 | | 9.993 | SIO2 | 1.476665 | 60.812 | |
| 8 | 731.755 | | 19.987 | | | 64.592 | |
| 9 | -176.716 | AS | 19.987 | | | 65.556 | Spiegel |
| 10 | 731.755 | | 9.993 | SIO2 | 1.476665 | 62.894 | |
| 11 | -121.656 | | 263.889 | | | 57.256 | |
| 12 | 2572.938 | AS | 328.866 | | | 89.074 | Spiegel |
| 13 | 610962.585 | | 35.081 | SIO2 | 1.476665 | 118.582 | |
| 14 | -301.935 | | 0.987 | | | 120.487 | |
| 15 | 252.420 | AS | 39.362 | SIO2 | 1.476665 | 125.076 | |
| 16 | 3344.838 | | 24.188 | | | 123.946 | |
| 17 | -433.934. | | 11.584 | SIO2 | 1.476665 | 123.348 | |

(fortgesetzt)

| Fläche | Radien | | Dicken | Material | Brechzahl | Linsenhöhe | |
|---|---|---|---|---|---|---|---|
| 18 | -528.911 | | 442.478 | | | 123.312 | |
| 19 | 199.347 | | 9.997 | SIO2 | 1.476665 | 66.871 | |
| 20 | 157.848 | | 8.412 | | | 64.492 | |
| 21 | 173.757 | AS | 54.819 | SIO2 | 1.476665 | 64.173 | |
| 22 | 350.831 | | 1.064 | | | 58.002 | |
| 23 | 113.866 | | 30.180 | SIO2 | 1.476665 | 58.181 | |
| 24 | -271.391 | AS | -13.314 | | | 58.058 | |
| 25 | 0.000 | | 14.329 | | | 58.197 | |
| 26 | 198.799 | | 15.126 | SIO2 | 1.476665 | 57.335 | |
| 27 | 90.489 | AS | 11.413 | | | 53.852 | |
| 28 | 127.813 | | 32.882 | SIO2 | 1.476665 | 54.867 | |
| 29 | -145.855 | | 0.935 | | | 54.918 | |
| 30 | 91.835 | | 40.128 | SIO2 | 1.476665 | 49.727 | |
| 31 | -236.843 | | 0.948 | | | 42.552 | |
| 32 | 1919.314 | | 24.911 | SIO2 | 1.476665 | 38.941 | |
| 33 | -160.166 | | 10.002 | | | 29.623 | |
| 34 | 0.000 | | 0.000 | | | 17.002 | |

**Tabelle 5A**

| Asphärische Konstanten | | | | |
|---|---|---|---|---|
| Fläche | 5 | 9 | 12 | 15 |
| K | 0 | 2.33780E+00 | 5.45689E+02 | 0.0000E+00 |
| C1 | -9.03933E-09 | 3.38168E-08 | -2.93438E-09 | -7.39968E-09 |
| C2 | -7.75667E-13 | 2.33448E-12 | -1.16949E-13 | 6.76552E-13 |
| C3 | 4.18118E-16 | 4.59303E-17 | 1.32890E-17 | -1.19953E-16 |
| C4 | -1.15658E-19 | 8.11037E-20 | -5.40050E-21 | 1.02568E-20 |
| C5 | 1.36650E-23 | -2.04337E-23 | 5.30199E-25 | -4.32962E-25 |
| C6 | -5.98713E-28 | 2.84062E-27 | -3.16329E-29 | 7.18020E-30 |
| Fläche | 21 | 24 | 27 | |
| K | 0.00000E+00 | 0.00000E+00 | 0 | |
| C1 | -1.50613E-07 | 1.12123E-07 | 2.2665E-07 | |
| C2 | -8.64207E-12 | 1.40224E-11 | 1.39902E-11 | |
| C3 | 4.90202E-16 | -1.39648E-16 | 1.40779E-17 | |
| C4 | 1.81224E-20 | 7.6095E-19 | -1.39321 E-18 | |
| C5 | 1.22465E-23 | -2.46722E-22 | 2.71948E-22 | |
| C6 | 1.91136E-28 | 2.15908E-26 | -2.76663E-26 | |

**Tabelle 6.**

| Typ | Design | NA | λ | RMS mono | DI | RMS poly | CHL | GF | DS | DL | TL |
|---|---|---|---|---|---|---|---|---|---|---|---|
| | | | nm | mλ | pm | mλ | nm/pm | nm/pm | mm | mm | mm |
| RCR | Tabelle 2 | 0,7 | 351 | 5,3 | 1000 | 8,1 | -0,06 | 0,1 | 330 | 222 | 1500 |
| RCR | Tabelle 2' | 0,7 | 365 | 6.0 | 2000 | 7,5 | -0,03 | 0,09 | 280 | 183 | 1520 |
| Cube | Tabelle 3 | 0,7 | 351 | 5,0 | 200 | 8,0 | -0,1 | 0,7 | 226 | 176 | 1145 |
| h | Tabelle 4 | 0,7 | 351 | 5,5 | 200 | 16,0 | -0,8 | 1,8 | 265 | 200 | 1182 |
| 2M | Tabelle 5 | 0,7 | 351 | 13,0 | 100 | 23,0 | -2,0 | 4,6 | 178 | 116 | 1288 |

**Patentansprüche**

1. Projektionsbelichtungsanlage zur Belichtung eines im Bereich einer Bildfläche eines Projektionsobjektivs angeordneten strahlungsempfindlichen Substrats mit mindestens einem Bild eines im Bereich einer Objektfläche des Projektionsobjektivs angeordneten Musters einer Maske umfassend:

   eine Lichtquelle zur Abgabe von Ultraviolettlicht aus einem Wellenlängenband mit einer Bandbreite $\Delta\lambda$ > 100 pm um eine zentrale Arbeitswellenlänger $\lambda$ > 320 nm;
   ein Beleuchtungssystem zum Empfang des Lichtes der Lichtquelle und zur Formung von auf das Muster der Maske gerichteter Beleuchtungsstrahlung; und
   ein Projektionsobjektiv zur verkleinernden Abbildung der Struktur der Maske auf ein lichtempfindliches Substrat mittels Projektionslicht aus einem Wellenlängenband mit einer Bandbreite $\Delta\lambda$ > 100 pm um eine zentrale Arbeitswellenlänge $\lambda$ > 320 nm bei einer bildseitigen numerischen Apertur NA > 0,6, **dadurch gekennzeichnet, dass**
   das Projektionsobjektiv ein katadioptrisches Projektionsobjektiv ist und mindestens einen Konkavspiegel enthält, der im Bereich einer Pupillenfläche des Projektionsobjektivs angeordnet ist und in unmittelbarer Nähe des Konkavspiegels in einem pupillennahen Bereich eine Negativgruppe mit mindestens einer Negativlinse derart angeordnet ist, dass zwischen der mindestens einen Negativlinse der Negativgruppe und dem Konkavspiegel kein weiteres optisches Element angeordnet ist, wobei in dem pupillennahen Bereich die Randstrahlhöhe der Abbildung größer ist als die Hauptstrahlhöhe, wobei das Projektionsobjektiv so ausgelegt ist, dass genau zwei Zwischenbilder zwischen der Objektfläche und der Bildfläche gebildet werden.

2. Projektionsbelichtungsanlage nach Anspruch 1, worin die Randstrahlhöhe im Bereich der Negativgruppe mindestens doppelt so groß ist wie die Hauptstrahlhöhe, vorzugsweise mindestens 5 mal so groß, insbesondere mindestens 10 mal so groß.

3. Projektionsbelichtungsanlage nach Anspruch 1 oder 2, worin die mindestens eine Negativlinse der Negativgruppe koaxial mit dem Konkavspiegel angeordnet ist.

4. Projektionsbelichtungsanlage nach einem der vorhergehenden Ansprüche, worin die Negativgruppe derart in unmittelbarer Nähe des Konkavspiegels angeordnet ist, dass die Negativgruppe von der Projektionsstrahlung zweifach in entgegengesetzten Durchstrahlungsrichtungen durchlaufen wird.

5. Projektionsbelichtungsanlage nach einem der vorhergehenden Ansprüche, worin die Negativgruppe mindestens eine zerstreuende Meniskuslinse enthält.

6. Projektionsbelichtungsanlage nach einem der vorhergehenden Ansprüche, worin Durchmesser und Brechkraft der mindestens einen Negativlinse der Negativgruppe so ausgelegt sind, dass eine Summe von überkorrigierenden Beiträgen der Negativgruppe zur Farbkorrektur mindestens 60% der Summe der unterkorrigierenden Beiträge der übrigen optischen Elemente des Projektionsobjektivs beträgt.

7. Projektionsbelichtungsanlage nach einem der vorhergehenden Ansprüche, worin mindestens 90% aller Linsen oder alle Linsen des Projektionsobjektivs aus einem oder mehreren Materialien gefertigt sind, die im Wesentlichen die gleiche Dispersion haben, wobei ein Dispersionsunterschied verwendeter Materialien kleiner ist als 10%, insbesondere kleiner als 5% ist.

8. Projektionsbelichtungsanlage nach einem der vorhergehenden Ansprüche, worin mindestens 90% aller Linsen des Projektionsobjektivs aus dem gleichen Material gefertigt sind

9. Projektionsbelichtungsanlage nach Anspruch 8, worin alle transparenten optischen Komponenten aus dem gleichen Material bestehen, wobei insbesondere das gleiche Material synthetisches Quarzglas ist.

10. Projektionsbelichtungsanlage nach einem der vorhergehenden Ansprüche, worin die Lichtquelle eine Quecksilberdampflampe mit einer zentralen Arbeitswellenlänge von etwa $\lambda$ = 365 nm enthält.

11. Projektionsbelichtungsanlage nach einem der Ansprüche 1 bis 9, worin die Lichtquelle ein XeF-Laser ist.

12. Projektionsbelichtungsanlage nach einem der Ansprüche 1 bis 9, worin die Lichtquelle mindestens eine lichtemittierende Diode (LED) enthält.

13. Projektionsbelichtungsanlage nach einem der vorhergehenden Ansprüche, worin das Projektionsobjektiv einen ersten Objektivteil zur Erzeugung eines ersten Zwischenbildes aus dem in der Objektfläche angeordneten Muster, einen zweiten Objektivteil zur Abbildung des ersten Zwischenbildes in ein zweites Zwischenbild, sowie einen dritten Objektivteil zur Abbildung des zweiten Zwischenbildes in die Bildfläche aufweist, wobei der erste Objektivteil ein refraktiver Objektivteil ist, der zweite Objektivteil ein katoptrischer oder katadioptrischer Objektivteil mit mindestens einem Konkavspiegel ist, und der dritte Objektivteil ein refraktiver Objektivteil ist.

14. Verwendung eines katadioptrischen Projektionsobjektivs mit mindestens einem Konkavspiegel, der im Bereich einer Pupillenfläche des Projektionsobjektivs angeordnet ist, und einer in unmittelbarer Nähe des Konkavspiegels in einem pupillennahen Bereich angeordneten Negativgruppe mit mindestens einer Negativlinse, wobei zwischen der Negativlinse und dem Konkavspiegel kein weiteres optisches Element angeordnet ist, wobei in dem pupillennahen Bereich die Randstrahlhöhe der Abbildung größer ist als die Hauptstrahlhöhe und wobei das Projektionsobjektiv so ausgelegt ist, dass genau zwei Zwischenbilder zwischen der Objektfläche und der Bildfläche gebildet werden zur verkleinernden Abbildung eines in einer Objektfläche des Projektionsobjektivs angeordneten Musters einer Maske in eine zur Objektfläche optisch konjugierte Bildfläche des Projektionsobjektivs mit Hilfe von Projektionslicht aus einem Wellenlängenband mit einer Bandbreite $\Delta\lambda$ > 100 pm um eine zentrale Arbeitswellenlänge $\lambda$ > 320 nm bei einer bildseitigen numerischen Apertur NA > 0,6

15. Verwendung nach Anspruch 14, worin das Projektionsobjektiv die Merkmale des Projektionsobjektivs aus mindestens einem der Ansprüche 2 bis 9 oder 13 aufweist.

16. Projektionsbelichtungsverfahren zur Belichtung eines im Bereich einer Bildfläche eines Projektionsobjektivs angeordneten, strahlungsempfindlichen Substrats mit mindestens einem Bild eines im Bereich einer Objektfläche des Projektionsobjektivs angeordneten Musters einer Maske mit:

Anordnen der Maske im Bereich der Objektfläche des Projektionsobjektivs;
Beleuchten der Maske mit Beleuchtungslicht aus einem Wellenlängenband mit einer Bandbreite $\Delta\lambda$ > 100 pm um eine zentrale Arbeitswellenlänge $\lambda$ > 320 nm;
verkleinerndes Abbilden des Musters der Maske mittels Projektionslicht aus einem Wellenlängenband mit einer Bandbreite $\Delta\lambda$ > 100 pm um eine zentrale Arbeitswellenlänge $\lambda$ > 320 nm bei einer bildseitigen numerischen Apertur NA > 0,6 mit Hilfe eines katadioptrischen Projektionsobjektivs, das mindestens einen Konkavspiegel enthält, der im Bereich einer Pupillenfläche des Projektionsobjektivs angeordnet ist, wobei in unmittelbarer Nähe des Konkavspiegels in einem pupillennahen Bereich eine Negativgruppe mit mindestens einer Negativlinse derart angeordnet ist, dass zwischen der Negativlinse und dem Konkavspiegel kein weiteres optisches Element angeordnet ist, wobei in dem pupillennahen Bereich die Randstrahlhöhe der Abbildung größer ist als die Hauptstrahlhöhe ist, und wobei das Projektionsobjektiv so ausgelegt ist, dass genau zwei Zwischenbilder zwischen der Objektfläche und der Bildfläche gebildet werden.

17. Projektionsbelichtungsverfahren nach Anspruch 16, worin das Projektionsobjektiv die Merkmale des Projektionsobjektivs aus mindestens einem der Ansprüche 2 bis 9 oder 13 aufweist.

**Claims**

1. Projection exposure apparatus for the exposure of a radiation-sensitive substrate arranged in the region of an image surface of a projection objective with at least one image of a pattern of a mask that is arranged in the region of an object surface of the projection objective, comprising:

   a light source for emitting ultraviolet light from a wavelength band having a bandwidth $\Delta\lambda > 100$ pm around a central operating wavelength $\lambda > 320$ nm;
   an illumination system for receiving the light from the light source and for shaping illumination radiation directed onto the pattern of the mask; and
   a projection objective for the demagnifying imaging of the structure of the mask onto a light-sensitive substrate by means of projection light from a wavelength band having a bandwidth $\Delta\lambda > 100$ pm around a central operating wavelength $\lambda > 320$ nm with an image-side numerical aperture NA > 0.6, **characterized in that** the projection objective is a catadioptric projection objective and contains at least one concave mirror which is arranged in the region of a pupil surface of the projection objective and a negative group having at least one negative lens is arranged in direct proximity to the concave mirror in a region near the pupil in such a way that no further optical element is arranged between the at least one negative lens of the negative group and the concave mirror, the marginal ray height of the imaging being greater than the chief ray height in the region near the pupil, the projection objective being designed such that exactly two intermediate images are formed between the object surface and the image surface.

2. Projection exposure apparatus according to Claim 1, wherein the marginal ray height is at least twice as large as the chief ray height in the region of the negative group, preferably at least 5 times as large, in particular at least 10 times as large.

3. Projection exposure apparatus according to Claim 1 or 2, wherein the at least one negative lens of the negative group is arranged coaxially with the concave mirror.

4. Projection exposure apparatus according to one of the preceding claims, wherein the negative group is arranged in direct proximity to the concave mirror in such a way that the projection radiation passes through the negative group twice in opposite through-radiating directions.

5. Projection exposure apparatus according to one of the preceding claims, wherein the negative group contains at least one diverging meniscus lens.

6. Projection exposure apparatus according to one of the preceding claims, wherein the diameter and refractive power of the at least one negative lens of the negative group are designed such that a sum of overcorrecting contributions of the negative group to the chromatic correction is at least 60% of the sum of the undercorrecting contributions of the remaining optical elements of the projection objective.

7. Projection exposure apparatus according to one of the preceding claims, wherein at least 90% of all the lenses or all the lenses of the projection objective are produced from one or a plurality of materials having essentially the same dispersion, a difference in dispersion of materials used being less than 10%, in particular less than 5%.

8. Projection exposure apparatus according to one of the preceding claims, wherein at least 90% of all the lenses of the projection objective are produced from the same material.

9. Projection exposure apparatus according to Claim 8, wherein all the transparent optical components consist of the same material, in particular the same material being synthetic fused silica.

10. Projection exposure apparatus according to one of the preceding claims, wherein the light source contains a mercury vapour lamp having a central operating wavelength of approximately $\lambda = 365$ nm.

11. Projection exposure apparatus according to one of Claims 1 to 9, wherein the light source is an XeF laser.

12. Projection exposure apparatus according to one of Claims 1 to 9, wherein the light source contains at least one light-emitting diode (LED).

**13.** Projection exposure apparatus according to one of the preceding claims, wherein the projection objective has a first objective part for generating a first intermediate image from the pattern arranged in the object surface, a second objective part for imaging the first intermediate image into a second intermediate image, and also a third objective part for imaging the second intermediate image into the image surface, the first objective part being a refractive objective part, the second objective part being a catoptric or catadioptric objective part with at least one concave mirror, and the third objective part being a refractive objective part.

**14.** Use of a catadioptric projection objective having at least one concave mirror which is arranged in the region of a pupil surface of the projection objective, and having a negative group having at least one negative lens arranged in direct proximity to the concave mirror in a region near the pupil, no further optical element being arranged between the negative lens and the concave mirror, the marginal ray height of the imaging being greater than the chief ray height in the region near the pupil, and the projection objective being designed such that exactly two intermediate images are formed between the object surface and the image surface
for the demagnifying imaging of a pattern of a mask that is arranged in an object surface of the projection objective into an image surface of the projection objective, which image surface is optically conjugate with respect to the object surface, with the aid of projection light from a wavelength band having a bandwidth $\Delta\lambda > 100$ pm around a central operating wavelength $\lambda > 320$ nm with an image-side numerical aperture NA > 0.6.

**15.** Use according to Claim 14, wherein the projection objective has the features of the projection objective from at least one of Claims 2 to 9 or 13.

**16.** Projection exposure method for the exposure of a radiation-sensitive substrate arranged in the region of an image surface of a projection objective with at least one image of a pattern of a mask that is arranged in the region of an object surface of the projection objective, comprising:

arranging the mask in the region of the object surface of the projection objective;
illuminating the mask with illumination light from a wavelength band having a bandwidth $\Delta\lambda > 100$ pm around a central operating wavelength $\lambda > 320$ nm;
demagnifying imaging of the pattern of the mask by means of projection light from a wavelength band having a bandwidth $\Delta\lambda > 100$ pm around a central operating wavelength $\lambda > 320$ nm with an image-side numerical aperture NA > 0.6 with the aid of a catadioptric projection objective containing at least one concave mirror which is arranged in the region of a pupil surface of the projection objective, a negative group having at least one negative lens being arranged in direct proximity to the concave mirror in a region near the pupil in such a way that no further optical element is arranged between the negative lens and the concave mirror, the marginal ray height of the imaging being greater than the chief ray height in the region near the pupil, and the projection objective being designed such that exactly two intermediate images are formed between the object surface and the image surface.

**17.** Projection exposure method according to Claim 16, wherein the projection objective has the features of the projection objective from at least one of Claims 2 to 9 or 13.

**Revendications**

**1.** Appareil d'exposition par projection destiné à exposer un substrat sensible au rayonnement disposé dans la région d'un plan image d'un objectif de projection comprenant au moins une image d'un motif d'un masque disposé dans la région d'un plan objet de l'objectif de projection, comprenant :

une source de lumière destinée à délivrer une lumière ultraviolette se situant dans une bande de longueurs d'onde ayant une largeur de bande de $\Delta\lambda > 100$ pm centrée sur une longueur d'onde centrale de fonctionnement de $\lambda > 320$ nm ;
un système d'exposition destiné à recevoir la lumière provenant de la source de lumière et à former un rayonnement d'exposition dirigé sur le motif du masque ; et
un objectif de projection destiné à former une image réduite de la structure du masque sur le substrat sensible à la lumière au moyen d'une lumière de projection se situant dans une bande de longueurs d'onde ayant une largeur de bande de $\Delta\lambda > 100$ pm centrée sur une longueur d'onde centrale de fonctionnement de $\lambda > 320$ nm avec une ouverture numérique du côté image de NA > 0,6, **caractérisé en ce que**
l'objectif de projection est un objectif de projection catadioptrique et comporte au moins un miroir concave qui est disposé dans la région d'un plan de pupille de l'objectif de projection et **en ce que**, à proximité immédiate du miroir concave, dans une région proche de la pupille, un groupe négatif comprenant au moins une lentille négative est disposé de manière à ce qu'il n'y ait pas d'autre élément optique disposé entre l'au moins une lentille négative du groupe négatif et le miroir concave, dans lequel, dans la région proche de la pupille, la hauteur des rayons marginaux de l'image formée est supérieure à la hauteur du rayon principal, l'objectif de projection étant conçu de manière à ce qu'exactement deux images intermédiaires soient formées entre le plan objet et le plan image.

**2.** Appareil d'exposition par projection selon la revendication 1, dans lequel la hauteur des rayons marginaux dans la région du groupe négatif est au moins deux fois supérieure à la hauteur du rayon principal, et est de préférence au moins cinq fois supérieure et notamment au moins dix fois supérieure.

**3.** Appareil d'exposition par projection selon la revendication 1 ou 2, dans lequel l'au moins une lentille négative du groupe négatif est disposée coaxialement par rapport au miroir concave.

**4.** Appareil d'exposition par projection selon l'une quelconque des revendications précédentes, dans lequel le groupe négatif est disposé à proximité immédiate du miroir concave de telle manière que le groupe négatif soit traversé deux fois par le rayonnement de projection dans des directions de rayonnement opposées.

**5.** Appareil d'exposition par projection selon l'une quelconque des revendications précédentes, dans lequel le groupe négatif comprend au moins une lentille ménisque diffusante.

**6.** Appareil d'exposition par projection selon l'une quelconque des revendications précédentes, dans lequel le diamètre et la puissance de réfraction de l'au moins une lentille négative du groupe négatif sont choisis de telle manière qu'une somme de contributions de sur-correction du groupe négatif à la correction de couleur s'élève à au moins 60 % de la somme des contributions de sous-correction des autres éléments optiques de l'objectif de projection.

**7.** Appareil d'exposition par projection selon l'une quelconque des revendications précédentes, dans lequel au moins 90 % de la totalité des lentilles ou la totalité des lentilles de l'objectif de projection sont fabriquées à partir d'un ou de plusieurs matériaux qui présentent sensiblement la même dispersion, dans lequel la différence de dispersion des matériaux utilisés est inférieure à 10 % et plus particulièrement inférieure à 5 %.

**8.** Appareil d'exposition par projection selon l'une quelconque des revendications précédentes, dans lequel au moins 90 % de la totalité des lentilles de l'objectif de projection sont fabriquées à partir du même matériau.

**9.** Appareil d'exposition par projection selon la revendication 8, dans lequel tous les composants optiques transparents sont constitués d'un matériau identique, ledit matériau identique étant en particulier un verre de quartz synthétique.

**10.** Appareil d'exposition par projection selon l'une quelconque des revendications précédentes, dans lequel la source de lumière comprend une lampe à vapeur de mercure ayant une longueur d'onde centrale de fonctionnement d'environ λ = 365 nm.

**11.** Appareil d'exposition par projection selon l'une quelconque des revendications 1 à 9, dans lequel la source de lumière est un laser XeF.

**12.** Appareil d'exposition par projection selon l'une quelconque des revendications 1 à 9, dans lequel la source de lumière comprend au moins une diode électroluminescente (LED).

**13.** Appareil d'exposition par projection selon l'une quelconque des revendications précédentes, dans lequel l'objectif de projection comprend une première partie d'objectif destinée à générer une première image intermédiaire à partir du motif disposé dans le plan objet, une deuxième partie d'objectif destinée à former l'image de la première image intermédiaire en une deuxième image intermédiaire, ainsi qu'une troisième partie d'objectif destinée à former l'image de la deuxième image intermédiaire dans le plan image, la première partie d'objectif étant une partie d'objectif de réfraction, la deuxième partie d'objectif étant une partie d'objectif catoptrique ou catadioptrique comprenant au moins un miroir concave, et la troisième partie d'objectif étant une partie d'objectif de réfraction.

**14.** Utilisation d'un objectif de projection catadioptrique comprenant au moins un miroir concave disposé dans la région d'un plan de pupille de l'objectif de projection, et un groupe négatif disposé à proximité immédiate du miroir concave

28

dans une région proche de la pupille, comprenant au moins une lentille négative, aucun autre élément optique n'étant disposé entre la lentille négative et le miroir concave, dans lequel la hauteur des rayons marginaux de l'image formée dans la région proche de la pupille est supérieure à la hauteur du rayon principal et dans lequel l'objectif de projection est conçu de telle manière qu'exactement deux images intermédiaires soient formées entre le plan objet et le plan image pour la formation d'une image réduite d'un motif d'un masque disposé dans un plan objet de l'objectif de projection, dans un plan image optiquement conjugué par rapport au plan objet de l'objectif de projection à l'aide d'une lumière de projection se situant dans une bande de longueurs d'onde ayant une largeur de bande de $\Delta\lambda >$ 100 pm centrée sur une longueur d'onde centrale de fonctionnement de $\lambda >$ 320 nm avec une ouverture numérique du côté image de NA > 0,6.

**15.** Utilisation selon la revendication 14, dans laquelle l'objectif de projection présente les caractéristiques de l'objectif de projection selon au moins l'une des revendications 2 à 9 ou 13.

**16.** Procédé d'exposition par projection destiné à exposer un substrat sensible au rayonnement disposé dans un plan image d'un objectif de projection à au moins une image d'un motif d'un masque disposé dans la région d'un plan objet de l'objectif de projection, consistant à :

disposer le masque dans la région du plan objet de l'objectif de projection ;
exposer le masque à une lumière d'exposition se situant dans une bande de longueurs d'onde ayant une largeur de bande de $\Delta\lambda >$ 100 pm centrée sur une longueur d'onde centrale de fonctionnement de $\lambda >$ 320 nm ;
former une image réduite du motif du masque au moyen d'une lumière de projection se situant dans une bande de longueurs d'onde ayant une largeur de bande de
$\Delta\lambda >$ 100 pm centrée sur une longueur d'onde centrale de fonctionnement de $\lambda^* >$ 320 nm avec une ouverture numérique du côté image de NA > 0,6 à l'aide d'un objectif de projection catadioptrique qui comporte au moins un miroir concave disposé dans la région du plan de pupille de l'objectif de projection, dans lequel un groupe négatif comprenant une lentille négative est disposé à proximité immédiate du miroir concave dans une région proche de la pupille, de manière à ce qu'aucun autre élément optique ne soit disposé entre la lentille négative et le miroir concave, dans lequel la hauteur des rayons marginaux de l'image formée dans la région proche de la pupille est supérieure à la hauteur du rayon principal et dans lequel l'objectif de projection est conçu de manière à ce qu'exactement deux images intermédiaires soient formées entre le plan objet et le plan image.

**17.** Procédé d'exposition par projection selon la revendication 16, dans lequel l'objectif de projection présente les caractéristiques de l'objectif de projection selon au moins l'une des revendications 2 à 9 ou 13.

Fig. 1

OA    OP1                    OP3  AS

OS  CR    P1    ImI1    ImI2    P3    IS

N2
NG
N1
OP2    P2

CM

Fig. 2

OP2

IMI    OA

FM

OF

OS    BSS
NL    BSC

RE    IS

OP1    AS

300

N2
      NG
N1

CM

Fig. 3

EP 1 855 160 B1

OP2

BS

FM1  FM2  IMI

OF

OS

NL

N2

N1

CM

OA

OP1  400

AS

IS

Fig. 4

EP 1 855 160 B1

Fig. 5

EP 1 855 160 B1

EP 1 855 160 B1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 2004099600 A2
- US 6424471 B1
- US 6665126 B2
- US 20030011755 A1
- EP 1069488 A1
- US 6600608 B
- DE 10221386 A1
- US 6806942 B2
- US 20050094289 A1
- GB 2428491 A
- US 60699483 B
- US 620978 A
- US 6909492 B2
- US 20040160677 A1
- EP 1069448 A1
- US 6636350 B
- US 6995918 B